# EUROPEAN PATENT APPLICATION

(11) **EP 4 216 694 A1**
(43) Date of publication of application: **26.07.2023**
(21) Application number: 23152653.4
(22) Date of filing: 20.01.2023
(51) Int. Cl.: H10K 59/122, H10K 59/80

(54) **DISPLAY DEVICE AND MANUFACTURING METHOD FOR THE SAME**

(30) Priority: 21.01.2022 KR 20220009469
(71) Applicant: Samsung Display Co., Ltd., Yongin-si, Gyeonggi-do (KR)
(72) Inventor: SUNG, Woo Yong, Yongin-si (KR); SONG, Seungyong, Yongin-si (KR); YOON, Kwanhyuck, Yongin-si (KR); LEE, Jeongseok, Yongin-si (KR)
(74) Representative: Marks & Clerk LLP

(57) **Abstract**

A display device includes a base layer, a circuit layer on the base layer, an auxiliary pixel defining layer disposed on the circuit layer and that includes a first opening adjacent to the circuit layer and a second opening above the first opening, an inorganic protective layer disposed on the auxiliary pixel defining layer and that includes a third opening above the second opening, a pixel defining layer disposed on the inorganic protective layer and that includes a fourth opening above the third opening, a light-emitting element disposed on the circuit layer and that includes a first electrode, a functional layer disposed on the first electrode, and a second electrode disposed on the functional layer, an auxiliary electrode layer that covers the pixel defining layer and the light-emitting element, and an inorganic layer disposed on the auxiliary electrode layer and that overlaps the pixel defining layer and the light-emitting element.

## Description

### TECHNICAL FIELD

Embodiments of the present disclosure are directed to a display device and a manufacturing method for the same, and more particularly, to a display device that has improved reliability by protecting a light-emitting element with an auxiliary electrode layer, and a manufacturing method for the same.

### DISCUSSION OF THE RELATED ART

A display device may include an organic electroluminescent material or a quantum dot light-emitting material. Such a light-emitting material is vulnerable to external substances such as oxygen and moisture, and thus functional layers are used to protect a light-emitting material.

In addition, foreign substances can be introduced into a display device during a manufacturing process such as forming these functional layers or providing and bonding members of the display device, and a light-emitting material can be exposed to an external environment, in which foreign substances can cause cracks. Accordingly, various techniques for sealing a light-emitting element are used. One technique is an encapsulation technology in which an encapsulation material is disposed on the light-emitting element to block the penetration path of air and moisture.

### SUMMARY

Embodiments of the present disclosure provide a display device with increased reliability by including an inorganic layer and an auxiliary electrode layer that directly cover a light-emitting element.

Embodiments of the present disclosure also provide a method for manufacturing a display device that includes a method of forming an auxiliary electrode layer and an inorganic layer that effectively cover a light-emitting element disposed in an opening.

An embodiment of the inventive concept provides a display device that includes: an auxiliary pixel defining layer that includes a first opening and a second opening formed above the first opening; an inorganic protective layer disposed on the auxiliary pixel defining layer and that includes a third opening formed above the second opening; a pixel defining layer disposed on the inorganic protective layer and that includes a fourth opening formed above the third opening; a light-emitting element; an auxiliary electrode layer that covers the pixel defining layer and the light-emitting element; and an inorganic layer disposed on the auxiliary electrode layer and that overlaps the pixel defining layer and the light-emitting element.

In an embodiment, the display device may further include a base layer; and a circuit layer disposed on the base layer, where the auxiliary pixel defining layer and the light-emitting element are disposed on the circuit layer and the first opening is adjacent to the circuit layer. In a cross section perpendicular to the base layer, a width of the first opening may be greater than a width of the second opening, the width of the second opening may be greater than a width of the third opening, and a width of the fourth opening may be greater than the width of the third opening.

In an embodiment, the light-emitting element may include a first electrode, a functional layer disposed on the first electrode, and a second electrode disposed on the functional layer. The first electrode may be disposed in the first opening, the functional layer may include a first sub-functional layer disposed on the first electrode in the first opening, and a second sub-functional layer disconnected from the first sub-functional layer and disposed on a side surface of the inorganic protective layer in the third opening, an upper surface of the inorganic protective layer exposed by the fourth opening, a side surface of the pixel defining layer defining the fourth opening, and an upper surface of the pixel defining layer, and the second electrode may include a first sub-electrode part disposed on the first sub-functional layer in the first opening, and a second sub-electrode part disconnected from the first sub-electrode part and disposed on the second sub-functional layer.

In an embodiment, the auxiliary electrode layer may be disposed directly on the first sub-electrode part and the second sub-electrode part, and may electrically connect the first sub-electrode part and the second sub-electrode part.

In an embodiment, the first sub-functional layer and the second sub-functional layer may be disconnected, and the auxiliary pixel defining layer may be exposed at a portion where the first sub-electrode part and the second sub-electrode part are disconnected, and the auxiliary electrode layer may cover the first sub-electrode part, the second sub-electrode part, and the auxiliary pixel defining layer exposed where the first sub-electrode part and the second sub-electrode part are disconnected.

In an embodiment, the inorganic layer may be disposed directly on the auxiliary electrode layer and may overlap an entirety of the auxiliary electrode layer.

In an embodiment, the display device may further include an auxiliary layer disposed on the inorganic layer. The auxiliary layer may include organic molecules that each include a hydrophilic portion adjacent to the inorganic layer and a hydrophobic portion spaced apart from the inorganic layer.

In an embodiment, the auxiliary layer may be a self-assembled monolayer.

In an embodiment, a contact angle of water on an upper surface of the auxiliary layer may be about 90 degrees or more.

In an embodiment, the auxiliary layer may include at least one of tridecafluoro-1,2,2-tetrahydrooctyl trichlorosilane (FOTS), perfluorodecyltrichlorosilane (FDTS), i-butyltrichlorosilane (IBTCS), decyltrichlorosilane (DTCS), octadecyl trichlorosilane (OTS), octyltrichlorosilane (OTCS), n-dodecyltrichlorosilane (DDTCS), trichloro(n-dodecyl)silane (FNTS), trichloro(3,3,3-trifluoropropyl)silane (FPTS), or methoxy polyethylene glycol silane (mPEGS).

In an embodiment, the first sub-functional layer may include a hole transport region, a light-emitting layer, and an electron transport region that are sequentially stacked, and the second sub-functional layer may include the hole transport region and the electron transport region, and may not include the light-emitting layer.

In an embodiment, an edge of the first electrode, an edge of the first sub-functional layer, and an edge of the first sub-electrode part may overlap each other in the first opening.

In an embodiment, the edge of the first electrode, the edge of the first sub-functional layer, and the edge of the first sub-electrode part may be in contact with the auxiliary pixel defining layer exposed by the first opening.

In an embodiment, the auxiliary electrode layer may include a transparent metal oxide.

In an embodiment, the auxiliary electrode layer may be provided by an atomic layer deposition method that uses an indium precursor.

In an embodiment, the inorganic layer may have a refractive index of about 1.9 or more at a wavelength of about 589 nm.

In an embodiment, the inorganic layer may include silicon nitride.

In an embodiment, the display device may further include: a sensor layer disposed on the inorganic layer; and a filling layer disposed between the inorganic layer and the sensor layer.

In an embodiment, the filling layer may fill the second to fourth openings.

In an embodiment of the inventive concept, a display device includes a display layer, a sensor layer disposed on the display layer, and a filling layer disposed between the display layer and the sensor layer. The display layer includes: a circuit layer; an auxiliary pixel defining layer that includes a first portion disposed directly on the circuit layer and a first opening, and a second portion disposed on the first portion, wherein the second portion is spaced apart from the circuit layer in a thickness direction and includes a second opening; an inorganic protective layer disposed on the auxiliary pixel defining layer and that includes a third opening; a pixel defining layer disposed on the inorganic protective layer and that includes a fourth opening; an auxiliary electrode layer that covers the pixel defining layer; and an inorganic layer disposed on the auxiliary electrode layer and that overlaps the pixel defining layer.

In an embodiment, the display layer may include: a first stepped portion defined by the first portion and the second portion; and a second stepped portion defined by the second portion and the third portion.

In an embodiment, the auxiliary electrode layer may include a transparent metal oxide.

In an embodiment, the inorganic layer may have a refractive index of about 2.0 or more at a wavelength of about 589 nm.

In an embodiment, the display layer may further include an auxiliary layer disposed on the inorganic layer. The auxiliary layer may include a hydrophilic portion adjacent to the inorganic layer and a hydrophobic portion spaced apart from the inorganic layer.

In an embodiment, the sensor layer may include a sensing base layer, a first conductive layer disposed on the sensing base layer, a second conductive layer disposed on the first conductive layer, and a sensing insulating layer disposed between the first conductive layer and the second conductive layer.

In an embodiment, the display layer may further include a light-emitting element that includes a first electrode disposed on the circuit layer, a functional layer disposed on the first electrode, and a second electrode disposed on the functional layer. The filling layer may overlap the pixel defining layer and an entirety of the light-emitting element.

In an embodiment, the filling layer may not overlap at least a portion of the pixel defining layer.

In an embodiment of the inventive concept, a method for manufacturing a display device includes: patterning a first electrode and a sacrificial layer on the circuit layer; forming a preliminary auxiliary pixel defining layer on the patterned sacrificial layer; forming a preliminary inorganic protective layer on the preliminary auxiliary pixel defining layer; forming a pixel defining layer on the preliminary inorganic protective layer and forming a pixel opening in the pixel defining layer that exposes a portion of an upper surface of the preliminary inorganic protective layer that overlaps the sacrificial layer; forming a mask layer that covers the pixel defining layer; forming an inorganic protective layer by patterning with the mask layer the preliminary inorganic protective layer, wherein an opening is formed in the inorganic protective layer that exposes an upper surface of the preliminary auxiliary pixel defining layer; forming an auxiliary pixel defining layer by patterning the preliminary auxiliary pixel defining layer, wherein an upper opening is formed in the auxiliary pixel defining layer that exposes the sacrificial layer; etching the exposed sacrificial layer and forming a lower opening that exposes an upper surface of the first electrode and the auxiliary pixel defining layer; forming a functional layer on the first electrode, the inorganic protective layer, and the pixel defining layer; forming a second electrode on the functional layer; forming an auxiliary electrode layer that covers the second electrode and the auxiliary pixel defining layer exposed by the upper opening; and forming an inorganic layer on the auxiliary electrode layer.

In an embodiment, forming the auxiliary electrode layer may include forming an auxiliary electrode layer that includes a transparent metal oxide using an atomic layer deposition method.

In an embodiment, forming the inorganic layer may include forming a silicon nitride-containing inorganic layer using an atomic layer deposition method.

In an embodiment, the method may further include forming, on the inorganic layer, an auxiliary layer that is a self-assembled monolayer that includes a hydrophilic portion and a hydrophobic portion.

In an embodiment, the method may further include forming a filling layer on the inorganic layer; and forming, on the filling layer, a sensor layer that comprises a sensing base layer, a first conductive layer, a sensing insulating layer, and a second conductive layer.

At least some of the above and features of the invention are set out in the claims.

### BRIEF DESCRIPTION OF THE FIGURES

FIG. 1 is a perspective view of a display device according to an embodiment.
FIG. 2 is an exploded perspective view of a display device according to an embodiment.
FIG. 3 is a cross-sectional view of a display device according to an embodiment.
FIG. 4 is a cross-sectional view of a display module according to an embodiment.
FIG. 5A is a cross-sectional view of a portion of a display module according to an embodiment.
FIG. 5B is a cross-sectional view of a portion of a display module according to an embodiment.
FIG. 6 is a cross-sectional view of a display module according to an embodiment.
FIG. 7 is a cross-sectional view of a display module according to an embodiment.
FIG. 8 is a cross-sectional view of a portion of a display module according to an embodiment.
FIG. 9A is a cross-sectional view of a portion of a display module according to an embodiment.
FIG. 9B is a graph showing a change in a contact angle of water over time.
FIG. 10 is a cross-sectional view of a portion of a display module according to an embodiment.
FIG. 11 is a flowchart of a method for manufacturing a display device according to an embodiment.
FIGS. 12A to 12I illustrate a method for manufacturing a display device according to an embodiment.

### DETAILED DESCRIPTION

In this specification, when an element (or a region, a layer, a portion, or the like) is referred to as "being on", "being connected to", or "being coupled to" another element, it may be directly disposed/connected/coupled to another element, or an intervening third element may also be disposed therebetween.

Like numbers or symbols may refer to like elements throughout.

The term "about" as used herein is inclusive of the stated value and means within an acceptable range of deviation for the particular value as determined by one of ordinary skill in the art, considering the measurement in question and the error associated with measurement of the particular quantity, such as the limitations of the measurement system. For example, "about" may mean within one or more standard deviations as understood by one of the ordinary skill in the art. Further, it is to be understood that while parameters may be described herein as having "about" a certain value, according to embodiments, the parameter may be exactly the certain value or approximately the certain value within a measurement error as would be understood by a person having ordinary skill in the art.

Hereinafter, a display device according to an embodiment of the inventive concept will be described with reference to the drawings.

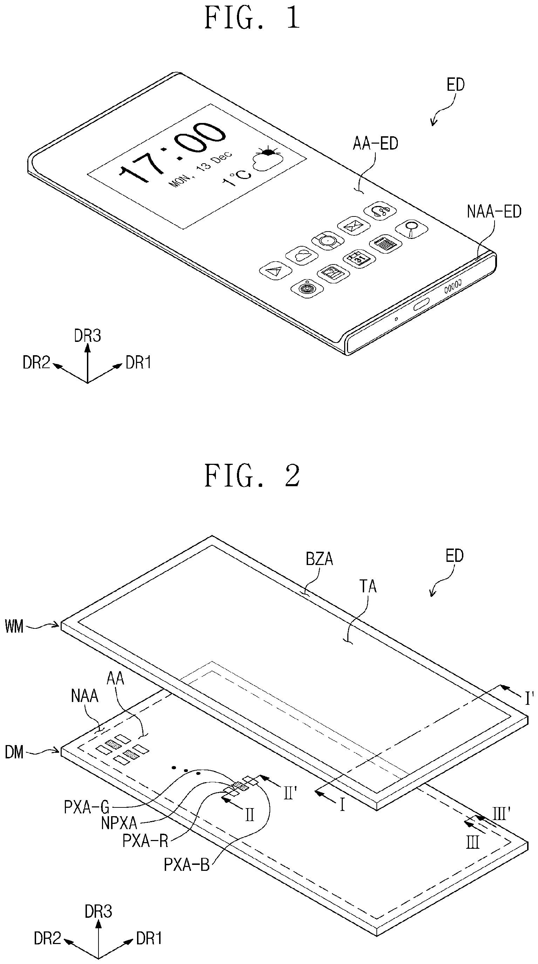

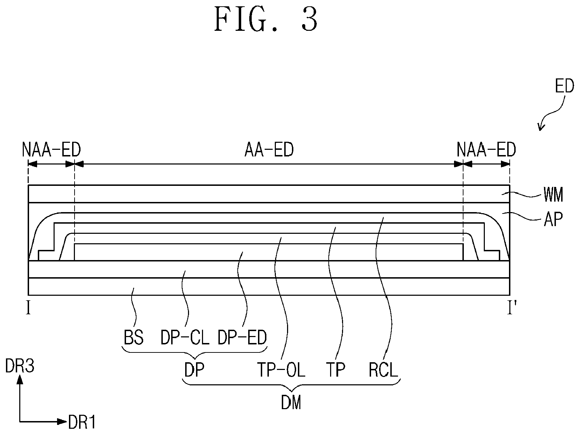

FIG. 1 is a perspective view of a display device according to an embodiment. FIG. 2 is an exploded perspective view of an electronic device according to an embodiment. FIG. 3 is a cross-sectional view of a display device according to an embodiment. FIG. 3 is a cross-sectional view taken along line I-I' of FIG. 2.

A display device ED according to an embodiment illustrated in FIGS. 1 to 3 is a device that is activated in response to an electrical signal. For example, the display device ED may be a mobile phone, a tablet PC, a vehicle navigation unit, a game console, or a wearable device, but embodiments are not necessarily limited thereto. In FIG. 1, the display device ED is a mobile phone.

The display device ED according to an embodiment displays an image through an active region AA-ED. The active region AA-ED is a plane defined by a first direction axis DR1 and a second direction axis DR2. The active region AA-ED further includes a curved surface that bends from at least one side of the plane defined by the first direction axis DR1 and the second direction axis DR2. FIG. 1 illustrates that the display device ED according to an embodiment includes two curved surfaces which are bent from two sides, respectively, of the plane defined by the first directional axis DR1 and the second directional axis DR2. However, the shape of the active region AA-ED is not necessarily limited thereto. For example, the active region AA-ED may include only the plane, or the active region AA-ED may further include four curved surfaces that bend respectively from at least two or more, for example, four sides of the plane.

A peripheral region NAA-ED is adjacent to the active region AA-ED. The peripheral region NAA-ED surrounds the active region AA-ED. Accordingly, the shape of the active region AA-ED is substantially defined by the peripheral region NAA-ED. However, embodiments are not necessarily limited thereto, and the peripheral region NAA-ED may be disposed adjacent to only one side of the active region AA-ED or omitted. The active region of the display device ED according to an embodiment of the inventive concept may have one of various shapes, and is not necessarily limited to one embodiment.

In FIG. 1 and the following drawings, first directional axis DR1 to third directional axis DR3 are illustrated. The directions indicated as the first to third directional axes DR1, DR2, and DR3 illustrated in the specification are relative and thus can be changed to other directions. In addition, the directions indicated as the first to third directional axes DR1, DR2, and DR3 may be referred to as first to third directions, and the same reference symbols may be used therefor. In this specification, the first direction axis DR1 is perpendicular to the second direction axis DR2, and the third direction axis DR3 is normal to the plane defined by the first direction axis DR1 and the second direction axis DR2.

The thickness direction of the display device ED is parallel to a third direction axis DR3. In this specification, a front surface (or a top surface) and a rear surface (or a bottom surface) of members of the display device ED are defined with respect to the third direction axis DR3.

The display device ED according to an embodiment includes a display module DM. The display module DM generates an image and senses an externally applied input. The display module DM according to an embodiment includes a display layer DP. The display module DM according to an embodiment further includes a sensor layer TP disposed on the display layer DP, and an optical layer RCL disposed on the sensor layer TP. The display module DM includes a filling layer TP-OL disposed between the display layer DP and the sensor layer TP. However, an embodiment of the inventive concept is not necessarily limited thereto, and the sensor layer TP or the optical layer RCL may be omitted.

An active region AA and a peripheral region NAA are defined in the display module DM. The active region AA is activated in response to an electrical signal. The peripheral region NAA is positioned adjacent to at least one side of the active region AA.

The active region AA corresponds to the active region AA-ED of the display device illustrated in FIG. 1. The peripheral region NAA surrounds the active region AA. However, an embodiment of the inventive concept is not necessarily limited thereto, and in an embodiment, a portion of the peripheral region NAA may be removed, unlike that illustrated in FIG. 2, etc. A driving circuit, a driving line, etc., that drive the active region AA are disposed in the peripheral region NAA.

The display device ED according to an embodiment includes a plurality of light-emitting regions PXA-R, PXA-G, and PXA-B. For example, the display device ED according to an embodiment includes a first light-emitting region PXA-R, a second light-emitting region PXA-G, and a third light-emitting region PXA-B. In an embodiment, the first light-emitting region PXA-R is a red light-emitting region that emits red light, the second light-emitting region PXA-G is a green light-emitting region that emits green light, and the third light-emitting region PXA-B is a blue light-emitting region that emits blue light.

When viewed on a plane defined by the first direction axis DR1 and the second direction axis DR2, for example, a plan view, the first to third light-emitting regions PXA-R, PXA-G, and PXA-B are separated without overlapping each other. For example, a non-light-emitting region NPXA is disposed between adjacent light-emitting regions PXA-R, PXA-G, and PXA-B.

FIG. 2 illustrates that the light-emitting regions PXA-R, PXA-G, and PXA-B are arranged in a row in the display device ED according to an embodiment. For example, in the display device ED according to an embodiment illustrated in FIG. 2, the first light-emitting region PXA-R, the second light-emitting region PXA-G, and the third light-emitting region PXA-B along the first direction axis DR1 are alternately arranged.

However, the arrangement of the light-emitting regions PXA-R, PXA-G, and PXA-B is not necessarily limited to that illustrated in FIG. 2, and the arrangement of the first light-emitting region PXA-R, the second light-emitting region PXA-G, and the third light-emitting region PXA-B can be reordered in various combinations according to characteristics of display quality required in the display device ED. For example, the arrangement of the light-emitting regions PXA-R, PXA-G, and PXA-B may be a PENTILE^{®} arrangement or a diamond arrangement.

In an embodiment, the light-emitting regions PXA-R, PXA-G, and PXA-B that emit light in different wavelength ranges have different areas, when viewed in a plan view. However, an embodiment of the inventive concept is not necessarily limited thereto. In an embodiment, the light-emitting regions PXA-R, PXA-G, and PXA-B have the same area. In addition, area ratios of the light-emitting regions can be variously adjusted according to the characteristics of display quality required in the display device ED, and shapes of the light-emitting regions PXA-R, PXA-G, and PXA-B on a plane can also be modified.

FIG. 2 illustrates each of the light-emitting regions PXA-R, PXA-G, and PXA-B as having a rectangular shape on a plane, but an embodiment of the inventive concept is not necessarily limited thereto. In embodiments, each of the light-emitting regions PXA-R, PXA-G, and PXA-B may have one of a polygonal, circular, or elliptical shape, etc., on a plane.

The display device ED further includes a window WM disposed on the display module DM. The window WM covers the entirety of the upper side of the display module DM. The window WM has a shape that corresponds to the shape of the display module DM. In the display device ED according to an embodiment, the window WM includes an optically transparent insulating material. The window WM may be one of a glass substrate or a polymer substrate. For example, the window WM is a tempered glass substrate on which a strengthening treatment was performed.

The window WM is divided into a transmission portion TA and a bezel portion BZA. The transmission portion TA corresponds to the active region AA of the display module DM, and the bezel portion BZA corresponds to the peripheral region NAA of the display module DM. The bezel portion BZA defines the shape of the transmission portion TA. The bezel portion BZA is adjacent to the transmission portion TA and surrounds the transmission portion TA. However, an embodiment of the inventive concept is not necessarily limited thereto, and in embodiments, the bezel portion BZA is disposed adjacent only to one side of the transmission portion TA, or is partially removed.

In the display device ED according to an embodiment, the display layer DP includes a base layer BS, a circuit layer DP-CL, and a display element layer DP-ED.

The sensor layer TP is disposed on the display layer DP. The sensor layer TP can sense an external input received from the outside. The external input may be a user's input. The user's input may be one of various types of external inputs, such as a portion of the user's body, light, heat, a pen, or pressure.

In the display device ED according to an embodiment, the filling layer TP-OL is disposed between the display layer DP and the sensor layer TP. The filling layer TP-OL is disposed directly on the display layer DP. Referring to FIG. 3, the filling layer TP-OL is a common layer disposed on the entirety of the active region AA-ED, and extends to the peripheral region NAA-ED. In an embodiment, the filling layer TP-OL is a single layer in the active region AA-ED and the peripheral region NAA-ED. However, an embodiment of the inventive concept is not necessarily limited thereto. In embodiments, the filling layer TP-OL is a single layer that covers the entirety of the display element layer DP-ED of the display layer DP, or is disposed on the display element layer DP-ED, covers the light-emitting regions PXA-R, PXA-G, PXA-B, and is patterned so as not to overlap a portion of the non-light-emitting region NPXA.

In the display module DM according to an embodiment, the sensor layer TP is formed on the filling layer TP-OL through a continuous process. The sensor layer TP is disposed directly on the filling layer TP-OL. "Disposed directly" may mean that a third component is not disposed between the sensor layer TP and the filling layer TP-OL. For example, no separate adhesive member is disposed between the sensor layer TP and the filling layer TP-OL.

The optical layer RCL is disposed on the sensor layer TP. The optical layer RCL is disposed on an upper side of the display layer DP and the sensor layer TP and controls light reflected from the display layer DP or the sensor layer TP. For example, the optical layer RCL reduces reflectance due to external light incident on the display module DM. The optical layer RCL includes, for example, a polarizing layer or a color filter layer. However, in an embodiment, the optical layer RCL is omitted from the display module DM. The display module DM may attached to the window WM by an adhesive layer AP.

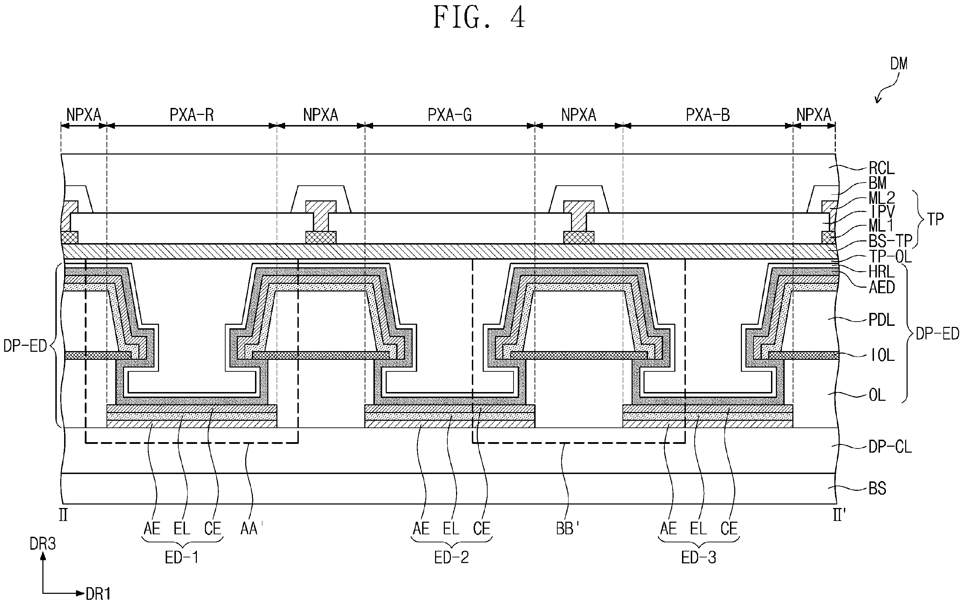

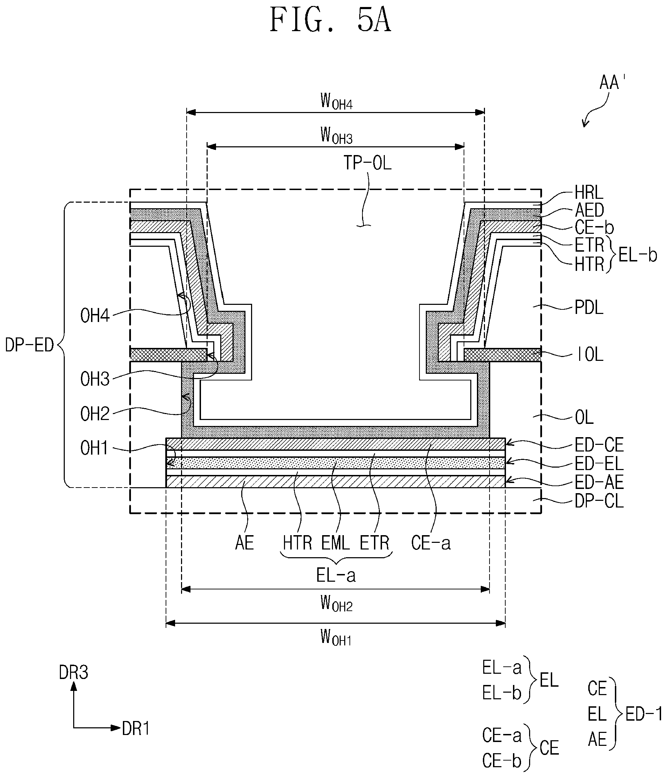

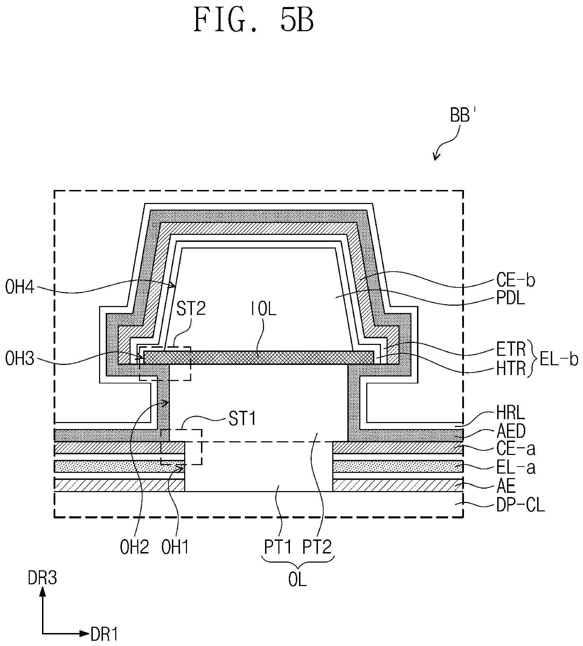

FIG. 4 is a cross-sectional view of the display module DM of the display device ED, according to an embodiment. FIG. 4 is a cross-sectional view taken along line II-II' of FIG. 2. FIG. 5A is a cross-sectional view of a portion of a display device according to an embodiment. FIG. 5B is a cross-sectional view of a portion of a display device according to an embodiment. FIG. 5A is a cross-sectional view of region AA' of FIG. 4, and FIG. 5B is a cross-sectional view of region BB' of FIG. 4.

In the display module DM according to an embodiment, the display layer DP includes light-emitting elements ED-1, ED-2, and ED-3. The display layer DP includes a plurality of light-emitting elements ED-1, ED-2, and ED-3 that are divided by a pixel defining layer PDL and an auxiliary pixel defining layer OL and correspond to the first to third light-emitting regions PXA-R, PXA-G, and PXA-B.

In the display module DM according to an embodiment, the display layer DP is a light-emitting type display layer. For example, the display layer DP is an organic electroluminescence display layer. When the display layer DP is an organic electroluminescence display layer, the display element layer DP-ED includes an organic electroluminescence element.

However, an embodiment of the inventive concept is not necessarily limited thereto. For example, in an embodiment, the display element layer DP-ED includes quantum dot light-emitting elements as the light-emitting elements ED-1, ED-2, and ED-3. In an embodiment, the display element layer DP-ED includes a micro LED element and/or a nano LED element as the light-emitting elements ED-1, ED-2, and ED-3.

In the display layer DP, the base layer BS provides a base surface on which the display element layer DP-ED is disposed. The base layer BS is one of a glass substrate, a metal substrate, a polymer substrate, etc. However, an embodiment of the inventive concept is not necessarily limited thereto, and in embodiments, the base layer BS is one of an inorganic layer, a functional layer, or a composite material layer.

The base layer BS has a multilayer structure. For example, in embodiments, the base layer BS has a three-layer structure of a polymer resin layer, a barrier layer, and a polymer resin layer, or a three-layer structure of a polymer resin layer, an adhesive layer, and a polymer resin layer. In particular, the polymer resin layer includes a polyimide-based resin. In addition, the polymer resin layer includes at least one of an acrylic resin, a methacrylic resin, a polyisoprene-based resin, a vinyl-based resin, an epoxy-based resin, a urethane-based resin, a cellulose-based resin, a siloxane-based resin, a polyamide-based resin, or a perylene-based resin.

In an embodiment, the circuit layer DP-CL is disposed on the base layer BS, and the circuit layer DP-CL includes a plurality of transistors. Each of the transistors includes a control electrode, an input electrode, and an output electrode. For example, the circuit layer DP-CL includes a switching transistor and a driving transistor that drive the light-emitting elements ED-1, ED-2, and ED-3 of the display element layer DP-ED.

The circuit layer DP-CL includes an insulating layer, a semiconductor pattern, a conductive pattern, a signal line, etc. The insulating layer, a semiconductor layer, and a conductive layer are formed on the base layer BS through a coating or deposition method, and subsequently, the insulating layer, the semiconductor layer, and the conductive layer are selectively patterned through a plurality of photolithography processes. Then, the semiconductor pattern, the conductive pattern, and the signal line of the circuit layer DP-CL are formed. In an embodiment, the circuit layer DP-CL includes a transistor, a buffer layer, and a plurality of insulating layers.

The display element layer DP-ED, which includes the light-emitting elements ED-1, ED-2, and ED-3, is disposed on the circuit layer DP-CL. The display element layer DP-ED includes an auxiliary pixel defining layer OL, an inorganic protective layer IOL, a pixel defining layer PDL, light-emitting elements ED-1, ED-2, and ED-3, an auxiliary electrode layer AED, and an inorganic layer HRL.

Each of the light-emitting elements ED-1, ED-2, and ED-3 includes a first electrode AE, a functional layer EL, and a second electrode CE. Referring to FIG. 5A, the functional layer EL includes a hole transport region HTR, a light-emitting layer EML, and an electron transport region ETR.

Although FIG. 5A illustrates the first light-emitting element ED-1 as corresponding to the first light-emitting region PXA-R, the stacked structure of the first light-emitting element ED-1 equally applies to the second light-emitting element ED-2 and the third light-emitting element ED-3. However, the configurations of the functional layers EL of the first to third light-emitting elements ED-1, ED-2, and ED-3 may be different from each other. For example, the first to third light-emitting elements ED-1, ED-2, and ED-3 have different configurations in the light-emitting layers EML thereof.

The respective light-emitting layers EML of the light-emitting elements ED-1, ED-2, and ED-3 that correspond to the light-emitting regions PXA-R, PXA-G, and PXA-B may all emit blue light or may emit light of different wavelength ranges. For example, in an embodiment, the light-emitting layer of the first light-emitting element ED-1 emits red light, the light-emitting layer of the second light-emitting element ED-2 emits green light, and the light-emitting layer of the third light-emitting element ED-3 emits blue light. However, an embodiment of the inventive concept is not necessarily limited thereto, and the wavelengths of light emitted from the first to third light-emitting elements ED-1, ED-2, and ED-3 can be variously combined according to display quality required in the display device.

Hereinafter, the first light-emitting element ED-1 illustrated in FIGS. 5A and 5B will be described, and the description of the first light-emitting element ED-1 equally applies to the second and third light-emitting elements ED-2 and ED-3, except for the configuration of the light-emitting layer.

In the light-emitting element ED-1, the first electrode AE may be an anode or cathode. In addition, the first electrode AE is a pixel electrode. The first electrode AE may be a transmissive electrode, a transflective electrode, or a reflective electrode. When the first electrode AE is a transmissive electrode, the first electrode AE includes a transparent metal oxide, such as one of indium tin oxide (ITO), indium zinc oxide (IZO), zinc oxide (ZnO), indium tin zinc oxide (ITZO), or the like. When the first electrode AE is a transflective electrode or a reflective electrode, the first electrode AE includes at least one of Ag, Mg, Cu, Al, Pt, Pd, Au, Ni, Nd, Ir, Cr, Li, Ca, LiF/Ca, LiF/Al, Mo, Ti, Yb, W, or a compound or mixture including the same. Alternatively, in an embodiment, the first electrode AE has a multilayer structure that includes a reflective or semi-transmission layer formed of at least one of the above materials and a transparent conductive layer formed of one of indium tin oxide (ITO), indium zinc oxide (IZO), zinc oxide (ZnO), indium tin zinc oxide (ITZO), etc. For example, the first electrode AE has a three-layer structure of ITO/Ag/ITO, but is not necessarily limited thereto.

The hole transport region HTR is disposed between the first electrode AE and the light-emitting layer EML. The hole transport region HTR includes at least one of a hole injection layer, a hole transport layer, or an electron blocking layer.

The hole transport region HTR includes at least one of N¹,N^{1'}-([1,1'-biphenyl]-4,4'-diyl)bis(N¹-phenyl-N⁴,N⁴-di-m-tolylbenzene-1,4-diamine) (DNTPD), 4,4',4"-[tris(3-methylphenyl)phenylamino] triphenylamine (m-MTDATA), 4,4'4"-tris(N,N-diphenylamino)triphenylamine (TDATA), 4,4',4"-tris[N(2-naphthyl)-N-phenylamino]-triphenylamine (2-TNATA), poly(3,4-ethylenedioxythiophene)/poly(4-styrenesulfonate) (PEDOT/PSS), polyaniline/dodecylbenzenesulfonic acid (PANI/DBSA), polyaniline/camphor sulfonic acid (PANI/CSA), polyaniline/poly(4-styrenesulfonate) (PANI/PSS), N,N'-di(naphthalene-1-yl)-N,N'-diphenyl-benzidine (NPB), polyetherketone-containing triphenylamine (TPAPEK), 4-isopropyl-4'-methyldiphenyliodonium [tetrakis(pentafluorophenyl)borate], or dipyrazino[2,3-f: 2',3'-h] quinoxaline-2,3,6,7,10,11-hexacarbonitrile (HATCN), etc.

The hole transport region HTR further includes at least one of a carbazole derivative such as N-phenylcarbazole and polyvinylcarbazole, a fluorene-based derivative, N,N'-bis(3-methylphenyl)-N,N'-diphenyl-[1,1'-biphenyl]-4,4'-diamine (TPD), a triphenylamine derivative such as 4,4',4"-tris(N-carbazolyl)triphenylamine (TCTA), N,N'-di(naphthalene-1-yl)-N,N'-diphenyl-benzidine (NPB), 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), or 1,3-bis(N-carbazolyl)benzene (mCP), etc.

The light-emitting layer EML is disposed on the hole transport region HTR. The light-emitting layer EML may have a single layer formed of a single material, a single layer formed of a plurality of different materials, or a multi-layered structure that has a plurality of layers formed of a plurality of different materials.

The light-emitting layer EML may include a fluorescent or a phosphorescent material. In a light-emitting element according to an embodiment, the light-emitting layer EML includes at least one of an anthracene derivative, a pyrene derivative, a fluoranthene derivative, a chrysene derivative, a dihydrobenzanthracene derivative, or a triphenylene derivative. In addition, the light-emitting layer EML includes a metal organic complex as a light-emitting material. However, in an embodiment, the light-emitting layer EML includes quantum dots as a light-emitting material.

The electron transport region ETR is disposed between the light-emitting layer EML and the second electrode CE. The electron transport region ETR includes at least one of an electron injection layer, an electron transport layer, or a hole blocking layer.

The electron transport region ETR includes, for example, at least one of tris(8-hydroxyquinolinato)aluminium (Alq3), 1,3,5-tri[(3-pyridyl)-phen-3-yl]benzene, 2,4,6-tris(3'-(pyridin-3-yl)biphenyl-3-yl)-1,3,5-triazine, 2-(4-(N-phenylbenzoimidazol-1 -yl)phenyl)-9,10-dinaphthylanthracene, 1,3,5-tri(1-phenyl-1H-benzo[d]imidazol-2-yl)benzene (TPBi), 2,9-dimethyl-4,7-diphenyl-1,10-phenanthroline (BCP), 4,7-diphenyl-1,10-phenanthroline (Bphen), 3-(4-biphenylyl)-4-phenyl-5-tert-butylphenyl-1,2,4-triazole (TAZ), 4-(naphthalen-1-yl)-3,5-diphenyl-4H-1,2,4-triazole (NTAZ), 2-(4-biphenylyl)-5-(4-tert-butylphenyl)-1,3,4-oxadiazole (tBu-PBD), bis(2-methyl-8-quinolinolato-N1,O8)-(1,1'-biphenyl-4-olato)aluminium (BAlq), berylliumbis(benzoquinolin-10-olate) (Bebq₂), 9,10-di(naphthalene-2-yl)anthracene (ADN), or 1,3-bis[3,5-di(pyridin-3-yl)phenyl]benzene (BmPyPhB), or a mixture thereof.

In addition, the electron transport region ETR further includes a metal halide such as NaCl, CsF, RbCl, RbI, CuI, or KI, a lanthanum group metal such as Yb, or a co-deposition material of the above-described metal halide and lanthanum group metal. For example, the electron transport region ETR includes KI:Yb, RbI:Yb, etc., as a co-deposition material. In addition, the electron transport region ETR includes one of a metal oxide such as Li₂O or BaO, or 8-hydroxyl-lithium quinolate (Liq), but an embodiment of the inventive concept is not necessarily limited thereto. The electron transport region ETR is formed of a material in which an electron transport material and an insulating organo metal salt are mixed.

The second electrode CE is disposed on the electron transport region ETR. The second electrode CE is a common electrode. The second electrode CE may be a cathode or anode, but an embodiment of the inventive concept is not necessarily limited thereto. For example, when the first electrode AE is an anode, the second electrode CE is a cathode, and when the first electrode AE is a cathode, the second electrode CE is an anode.

The second electrode CE may be a transmissive electrode, a transflective electrode, or a reflective electrode. When the second electrode CE is a transmissive electrode, the second electrode CE is formed of a transparent metal oxide, such as one of indium tin oxide (ITO), indium zinc oxide (IZO), zinc oxide (ZnO), indium tin zinc oxide (ITZO), etc.

Referring to FIGS. 4 to 5B, in the display module DM according to an embodiment, the light-emitting elements ED-1, ED-2, and ED-3 are divided by an auxiliary pixel defining layer OL and a pixel defining layer PDL. The pixel defining layer PDL is disposed above the auxiliary pixel defining layer OL. The auxiliary pixel defining layer OL and the pixel defining layer PDL correspond to the non-light-emitting region NPXA.

The auxiliary pixel defining layer OL is disposed on the circuit layer DP-CL. The auxiliary pixel defining layer OL may be formed of a polymer resin. For example, the auxiliary pixel defining layer OL includes a polyacrylate-based resin or a polyimide-based resin. In addition, the auxiliary pixel defining layer OL may further include an inorganic material in addition to the polymer resin. In addition, the auxiliary pixel defining layer OL may include a light absorbing material or may include a black pigment or a black dye.

A first opening OH1 and a second opening OH2 are formed in the auxiliary pixel defining layer OL. The first opening OH1 penetrates the circuit layer DP-CL, and the second opening OH2 is formed over the first opening OH1. In this specification, the first opening OH1 may be referred to as a lower opening, and the second opening OH2 may be referred to as an upper opening.

One surface of the auxiliary pixel defining layer OL is exposed in each of the first opening OH1 and the second opening OH2. A width W_{OH1} of the first opening OH1 on a cross section perpendicular to the base layer BS is greater than a width W_{OH2} of the second opening OH2. In an embodiment, the auxiliary pixel defining layer OL includes a first stepped portion ST1 defined by the first opening OH1 and the second opening OH2. The first stepped portion ST1 is formed by the difference in the width of the first opening OH1 and the width of the second opening OH2. The first stepped portion ST1 has an undercut shape that is concave inward from the auxiliary pixel defining layer OL.

The auxiliary pixel defining layer OL overlaps a portion of the light-emitting elements ED-1, ED-2, and ED-3. The auxiliary pixel defining layer OL covers a portion of the first electrode AE. The light-emitting regions PXA-R, PXA-G, and PXA-B correspond to a partial region of the first electrode AE exposed by the first opening OH1. The non-light-emitting region NPXA surrounds the light light-emitting regions PXA-R, PXA-G, and PXA-B. In an embodiment, the auxiliary pixel defining layer OL defines boundaries of the light-emitting regions PXA-R, PXA-G, and PXA-B. The light-emitting regions PXA-R, PXA-G, and PXA-B and the non-light-emitting region NPXA are divided by the auxiliary pixel defining layer OL.

The inorganic protective layer IOL is disposed on the auxiliary pixel defining layer OL. The inorganic protective layer IOL may include one of silicon nitride, silicon oxide, or silicon oxynitride. For example, the inorganic protective layer IOL is formed by forming a silicon nitride layer and then etching the silicon nitride layer.

A third opening OH3 is formed in the inorganic protective layer IOL. The third opening OH3 is formed on the second opening OH2. The third opening OH3 may be referred to as an inorganic layer opening.

In an embodiment, a width W_{OH3} of the third opening OH3 on a cross section perpendicular to the base layer BS is less than the width W_{OH2} of the second opening OH2. The display layer DP includes a second stepped portion ST2 that corresponds to a difference in width between the second opening OH2 and the third opening OH3. The second stepped portion ST2 has an undercut shape.

The pixel defining layer PDL is disposed on the inorganic protective layer IOL. In an embodiment, the pixel defining layer PDL is formed of a polymer resin. For example, the pixel defining layer PDL includes one of a polyacrylate-based resin or a polyimide-based resin. In addition, the pixel defining layer PDL may further include an inorganic material. For example, the pixel defining layer PDL includes one of silicon nitride, silicon oxide, or silicon oxynitride.

Furthermore, the pixel defining layer PDL may include a light absorbing material such as a black pigment or a black dye. When the pixel defining layer PDL includes a black pigment or a black dye, the pixel defining layer PDL may be referred to as a black pixel defining layer. Carbon black, etc., can be used as the black pigment or the black dye when the pixel defining layer PDL is formed, but an embodiment of the inventive concept is not necessarily limited thereto.

A fourth opening OH4 is formed in the pixel defining layer PDL. The fourth opening OH4 may be referred to as a pixel opening. The fourth opening OH4 is formed on the third opening OH3. In an embodiment, the first to fourth openings OH1, OH2, OH3, and OH4 sequentially overlap each other.

A width W_{OH4} of the fourth opening OH4 on a cross section perpendicular to the base layer BS is greater than the width W_{OH3} of the third opening OH3. The width W_{OH4} of the fourth opening OH4 gradually increases in the third direction axis DR3 away from the inorganic protective layer IOL. However, an embodiment of the inventive concept is not necessarily limited thereto.

Referring to FIG. 5B, in an embodiment, the auxiliary pixel defining layer OL includes a first portion PT1 disposed directly on the circuit layer DP-CL and a second portion PT2 spaced apart from the circuit layer DP-CL in the thickness direction and disposed directly on the first portion PT1.

The undercut-shaped first stepped portion ST1 is defined by the first portion PT1 and the second portion PT2 of the auxiliary pixel defining layer OL. The first stepped portion ST1 corresponds to a difference in position between an edge of the first portion PT1 and an edge of the second portion PT2. In addition, the undercut-shaped second stepped portion ST2 is defined by the second portion PT2 of the auxiliary pixel defining layer OL and the inorganic protective layer IOL. The second stepped portion ST2 corresponds to a difference in position between the edge of the second portion PT2 and an edge of the inorganic protective layer IOL.

For example, the display module DM according to an embodiment includes two or more undercut-shaped stepped portions ST1 and ST2 below the pixel defining layer PDL. Edges of the first electrode AE, the functional layer EL, and the second electrode CE are disposed in the first stepped portion ST1 below the pixel defining layer PDL such that the configurations of the light-emitting elements ED-1, ED-2, and ED-3 in the light-emitting regions PXA-R, PXA-G, and PXA-B are effectively protected by an auxiliary electrode layer AED, etc., which will be described below.

Referring to FIGS. 5A and 5B, in an embodiment, the functional layer EL of the light-emitting element ED-1 includes a first sub-functional layer EL-a and a second sub-functional layer EL-b. The first sub-functional layer EL-a is a portion disposed in the first opening OH1, and the second sub-functional layer EL-b is a portion that is disconnected from the first sub-functional layer EL-a and is disposed at a portion other than the first opening OH1. The second sub-functional layer EL-b is disposed on a side surface of the pixel defining layer PDL and an upper surface of the pixel defining layer PDL. In addition, the second sub-functional layer EL-b is further disposed on a side surface of the inorganic protective layer IOL in the third opening OH3 and an upper surface of the inorganic protective layer IOL exposed by the fourth opening OH4.

The first sub-functional layer EL-a includes a hole transport region HTR, a light-emitting layer EML, and an electron transport region ETR that are sequentially stacked. The second sub-functional layer EL-b includes a hole transport region HTR and an electron transport region ETR. In an embodiment, the second sub-functional layer EL-b does not include a light-emitting layer EML. However, an embodiment of the inventive concept is not necessarily limited thereto, and in an embodiment, the second sub-functional layer EL-b includes a portion of the light-emitting layer EML that is disconnected from the light-emitting layer EML of the first sub-functional layer EL-a.

Due to the undercut-shaped auxiliary pixel defining layer OL and the inorganic protective layer IOL, a portion that lacks the functional layer EL is generated in a portion of the stepped portion ST1 and ST2 when the functional layer EL is deposited. Accordingly, a disconnected portion is present between the first sub-functional layer EL-a and the second sub-functional layer EL-b. An edge portion ED-EL of the first sub-functional layer EL-a is in contact with the auxiliary pixel defining layer OL exposed by the first opening OH1, and an exposed surface of the first sub-functional layer EL-a is protected by the auxiliary pixel defining layer OL.

In an embodiment, the second electrode CE of the light-emitting element ED-1 includes a first sub-electrode part CE-a and a second sub-electrode part CE-b. The first sub-electrode part CE-a is disposed in the first opening OH1, and the second sub-electrode part CE-b is disconnected from the first sub-electrode part CE-a and is not disposed in the first opening OH1. The second sub-electrode part CE-b is disposed on the side surface of the pixel defining layer PDL and the upper surface of the pixel defining layer PDL. In addition, the second sub-electrode part CE-b is further disposed on a side surface of the inorganic protective layer IOL that defines the third opening OH3 and an upper surface of the inorganic protective layer IOL exposed by the fourth opening OH4. The first sub-electrode part CE-a is disposed on the first sub-functional layer EL-a, and the second sub-electrode part CE-b is disposed on the second sub-functional layer EL-b.

Due to the undercut-shaped auxiliary pixel defining layer OL, a portion in which the second electrode CE is not provided is generated in a portion of the stepped portion ST1 and ST2 when the second electrode CE is deposited. Accordingly, the first sub-electrode part CE-a and the second sub-electrode part CE-b are disconnected. A portion of an edge ED-CE of the first sub-electrode part CE-a is in contact with the auxiliary pixel defining layer OL exposed by the first opening OH1, and is protected by the auxiliary pixel defining layer OL.

In addition, the first sub-functional layer EL-a and the second sub-functional layer EL-b are disconnected, and a portion of the auxiliary pixel defining layer OL and the inorganic protective layer IOL are exposed where the first sub-electrode part CE-a and the second sub-electrode part CE-b are disconnected. The exposed auxiliary pixel defining layer OL and the exposed inorganic protective layer IOL are covered with an auxiliary electrode layer AED, which will be described below.

In an embodiment, in the first opening OH1, an edge ED-AE of the first electrode AE, the edge ED-EL of the first sub-functional layer EL-a, and the edge ED-CE of the first sub-electrode part CE-a overlap. For example, the edge ED-AE of the first electrode AE, the edge ED-EL of the first sub-functional layer EL-a, and the edge ED-CE of the first sub-electrode part CE-a are aligned with each other. The edge ED-AE of first electrode AE, the edge ED-EL of the first sub-functional layer EL-a, and the edge ED-CE of the first sub-electrode part CE-a are in contact with the auxiliary pixel defining layer OL exposed by the first opening OH1.

The display module DM according to an embodiment includes the auxiliary electrode layer AED disposed on light-emitting elements ED-1, ED-2, and ED-3. The auxiliary electrode layer AED entirely covers configurations of the light-emitting element disposed in the first opening OH1, configurations of the light-emitting element not disposed in the first opening OH1, and configurations of the auxiliary pixel defining layer OL and the pixel defining layer PDL. Referring to FIG. 4, the auxiliary electrode layer AED is a common layer on the entirety of the light-emitting regions PXA-R, PXA-G, and PXA-B and the non-light-emitting region NPXA.

The auxiliary electrode layer AED covers the light-emitting elements ED-1, ED-2, and ED-3 disposed in the first opening OH1, the auxiliary pixel defining layer OL exposed by the second opening OH2, etc.

The auxiliary electrode layer AED may include a transparent metal oxide. For example, the auxiliary electrode layer AED includes indium tin oxide (ITO). The auxiliary electrode layer AED is formed by an atomic layer deposition method. For example, the auxiliary electrode layer AED is formed by atomic layer deposition using an indium precursor.

Figures 4, 5A and 5B illustrate an embodiment in which the auxiliary electrode layer AED is a single layer, but an embodiment of the inventive concept is not necessarily limited thereto, and in an embodiment, the auxiliary electrode layer AED includes a plurality of layers. When the auxiliary electrode layer AED includes a plurality of layers, each layer is formed by atomic layer deposition.

The auxiliary electrode layer AED functions as a barrier layer that protects the light-emitting elements ED-1, ED-2, and ED-3 from moisture and oxygen. In addition, the auxiliary electrode layer AED is electrically connected to the second electrode CE.

Referring to FIGS. 4 to 5B, the auxiliary electrode layer AED covers the entirety of the light-emitting elements ED-1, ED-2, and ED-3, the exposed auxiliary pixel defining layer OL, and the pixel defining layer PDL. Accordingly, the auxiliary electrode layer AED electrically connects the disconnected first sub-electrode part CE-a and the second sub-electrode part CE-b of the second electrode CE. That is, the auxiliary electrode layer AED is provided on each of the first sub-electrode part CE-a and the second sub-electrode part CE-b, and also where the first sub-electrode part CE-a and the second sub-electrode part CE-b are disconnected, so that the first sub-electrode part CE-a and the second sub-electrode part CE-b are electrically connected to each other. The auxiliary electrode layer AED electrically connects the second electrode CE, and also reduces the resistance of the second electrode CE.

The auxiliary electrode layer AED covers the first sub-electrode part CE-a, the second sub-electrode part CE-b, and the auxiliary pixel defining layer OL exposed at a disconnected portion. In addition, the auxiliary electrode layer AED overlaps the first sub-functional layer EL-a and the second sub-functional layer El-b, so that the configurations of light-emitting elements such as the first sub-functional layer EL-a and the second sub-functional layer El-b are effectively protected.

In addition, in an embodiment, the auxiliary electrode layer AED is a capping layer of the light-emitting elements ED-1, ED-2, and ED-3. The auxiliary electrode layer AED may have a refractive index value of about 1.8 to about 1.9 and increases light extraction efficiency of the light-emitting elements ED-1, ED-2, and ED-3. For example, the auxiliary electrode layer AED includes ITO and has a refractive index value of about 1.89 at a wavelength of about 590nm. However, an embodiment of the inventive concept is not necessarily limited thereto.

The display module DM according to an embodiment includes the inorganic layer HRL disposed on the auxiliary electrode layer AED. The inorganic layer HRL is disposed directly on the auxiliary electrode layer AED. In an embodiment, the inorganic layer HRL includes at least one of silicon nitride, silicon oxynitride, or silicon oxide. In addition, in an embodiment, the inorganic layer HRL further includes titanium oxide or aluminium oxide, but an embodiment of the inventive concept is not necessarily limited thereto. In an embodiment, the inorganic layer HRL is formed by atomic layer deposition. For example, the inorganic layer HRL is formed by atomic layer deposition using an inorganic material such as silicon nitride.

In an embodiment, the refractive index of the inorganic layer HRL is greater than that of the auxiliary electrode layer AED. However, an embodiment of the inventive concept is not necessarily limited thereto. In embodiments, the inorganic layer HRL has a refractive index value of from about 1.9 to about 2.1. For example, the inorganic layer HRL includes silicon nitride and has a refractive index value of about 2.02 at a wavelength of about 589.3 nm.

In an embodiment, a stacked configuration of the auxiliary electrode layer AED and the inorganic layer HRL in the display element layer DP-ED is a capping layer of the light-emitting elements ED-1, ED-2, and ED-3. For example, in the display module DM according to an embodiment, the light-emitting elements ED-1, ED-2, and ED-3 do not include a capping layer. The stacked configuration of the auxiliary electrode layer AED and the inorganic layer HRL may have a refractive index value from about 1.8 to about 2.0 and increases light extraction efficiency in the light-emitting elements ED-1, ED-2, and ED-3. Since the display module DM according to an embodiment includes the stacked configuration of the auxiliary electrode layer AED and the inorganic layer HRL, the light-emitting elements ED-1, ED-2, and ED-3 can be effectively protected from moisture/oxygen, etc. and to exhibit an improved light extraction effect.

The display module DM according to an embodiment includes the filling layer TP-OL disposed on the display element layer DP-ED. The filling layer TP-OL fills a portion of an open region in the display element layer DP-ED in which a light-emitting element ED-1, ED-2, and ED-3, an auxiliary electrode layer AED, an inorganic layer HRL, etc., are not disposed.

The filling layer TP-OL is disposed on the inorganic layer HRL. The filling layer TP-OL is disposed directly on the inorganic layer HRL. In the display module DM according to an embodiment, the filling layer TP-OL fills a region between the display layer DP and the sensor layer TP.

The filling layer TP-OL may include an organic polymer material. For example, the filling layer TP-OL is formed of an acrylate-based resin, an imide-based resin, etc. For example, the filling layer TP-OL includes at least one of an acrylate-based polymer, an imide-based polymer, etc.

Referring to FIG. 4, in the display module DM according to an embodiment, the filling layer TP-OL overlaps the entirety of the light-emitting regions PXA-R, PXA-G, and PXA-B and the non-light-emitting region NPXA. The filling layer TP-OL is a common layer that covers the entirety of the light-emitting regions PXA-R, PXA-G, and PXA-B and the non-light-emitting region NPXA.

The display module DM according to an embodiment includes the sensor layer TP disposed on an upper side of the filling layer TP-OL. In an embodiment, the sensor layer TP is disposed directly on the filling layer TP-OL. The sensor layer TP may be referred to as a sensor, an input sensing layer, or an input sensing panel. In an embodiment, the sensor layer TP includes a sensing base layer BS-TP, a first conductive layer ML1, a sensing insulating layer IPV, and a second conductive layer ML2.

The sensing base layer BS-TP is disposed directly on the filling layer TP-OL. The sensing base layer BS-TP is an inorganic layer that may include at least one of silicon nitride, silicon oxynitride, or silicon oxide. Alternatively, in an embodiment, the sensing base layer BS-TP is an organic layer that includes at least one of an epoxy resin, an acryl resin, or an imide-based resin. The sensing base layer BS-TP may have a single-layer structure or a multilayer structure in which layers are stacked along the third direction axis DR3.

Each of the first conductive layer ML1 and the second conductive layer ML2 may have a single-layered structure or a multi-layered structure in which layers are stacked along the third direction axis DR3. A single layer conductive layer includes one of a metal layer or a transparent conductive layer. The metal layer includes at least one of molybdenum, silver, titanium, copper, aluminium, or an alloy thereof. The transparent conductive layer includes a transparent conductive oxide such as one of indium tin oxide (ITO), indium zinc oxide (IZO), zinc oxide (ZnO), zinc peroxide (ZnO₂) or indium zinc tin oxide (IZTO). In addition, the transparent conductive layer may include a conductive polymer such as PEDOT, metal nanowires, graphene, etc.

A multi-layered conductive layer includes metal layers. The metal layers may have, for example, a three-layer structure of titanium/aluminium/titanium. A multi-layered conductive layer includes at least one metal layer and at least one transparent conductive layer.

The sensing insulating layer IPV is disposed between the first conductive layer ML1 and the second conductive layer ML2. The sensing insulating layer IPV may include an inorganic layer. For example, the inorganic layer includes at least one of aluminium oxide, titanium oxide, silicon oxide, silicon nitride, silicon oxynitride, zirconium oxide, or hafnium oxide.

Alternatively, in an embodiment, the sensing insulating layer IPV includes an organic layer. For example, the organic layer includes at least one of an acryl-based resin, a methacrylic resin, polyisoprene, a vinyl-based resin, an epoxy-based resin, a urethane-based resin, a cellulose-based resin, a siloxane-based resin, a polyimide-based resin, a polyamide-based resin, or a perylene-based resin.

In an embodiment, the display module DM further includes the optical layer RCL disposed on the sensor layer TP. For example, the optical layer RCL is formed on the sensor layer TP through a continuous process. However, an embodiment of the inventive concept is not necessarily limited thereto.

The optical layer RCL includes a pigment or a dye. In addition, the optical layer RCL includes a plurality of filter units that transmit light of different wavelength ranges. Each of the filter units that transmits light of different wavelength ranges correspond to one of the light-emitting regions PXA-R, PXA-G, and PXA-B.

The optical layer RCL further includes a partition pattern BM. A material constituting the partition pattern BM is not particularly limited as long as the material absorbs light. The partition pattern BM is black, and in an embodiment of the inventive concept, the partition pattern BM contains a black coloring agent. The black coloring agent contains a black dye and a black pigment. The black coloring agent is one of carbon black, a metal such as chromium, or an oxide thereof.

The partition pattern BM covers the second conductive layer ML2 of the sensor layer TP. The partition pattern BM prevents reflection of external light by the second conductive layer ML2.

The display device ED according to an embodiment described with reference to FIGS. 1 to 5B includes the auxiliary pixel defining layer OL in which the first opening OH1 and the second opening OH2 are formed, and the light-emitting elements ED-1, ED-2, and ED-3 disposed in the first opening OH1 are protected by being covered with the auxiliary electrode layer AED and the inorganic layer HRL, thereby exhibiting excellent reliability characteristics. For example, in the display device ED according to an embodiment, since a portion of each of the light-emitting elements ED-1, ED-2, and ED-3 disposed in the first opening OH1 is covered with the auxiliary electrode layer AED and the inorganic layer HRL, the light-emitting elements ED-1, ED-2, and ED-3 are effectively protected from foreign substances, moisture, oxygen, etc., without introducing a separate encapsulation member in the display device. In addition, the display device ED according to an embodiment includes the light-emitting elements ED-1, ED-2, and ED-3 that are covered with an auxiliary electrode layer AED and an inorganic layer HRL, and are separated and protected from each other, so that the configuration of each of the light-emitting elements ED-1, ED-2, and ED-3 that respectively correspond to the light-emitting regions PXA-R, PXA-G, and PXA-B is independently protected. Accordingly, since limitations, such as propagation of defects in the encapsulation member caused when the typical encapsulation member covers the entirety of the light-emitting elements as a common layer, are prevented, the display device exhibits increased reliability characteristics, and the yield of a display device manufacturing process is increased. In addition, the display device ED according to an embodiment includes an inorganic layer HRL that has a relatively high refractive index on the upper portion of the light-emitting elements ED-1, ED-2, and ED-3 such that the inorganic layer HRL functions as a capping layer of a typical light-emitting element. For example, the display device ED exhibits high light extraction efficiency by including the auxiliary electrode layer AED and the inorganic layer HRL, which are disposed on the upper portion of the light-emitting elements ED-1, ED-2, and ED-3.

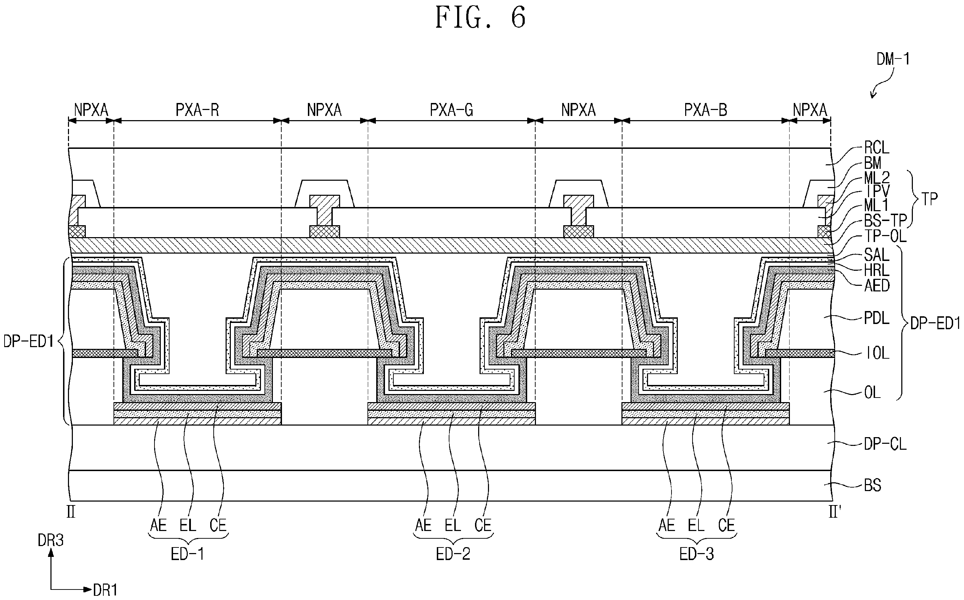

Hereinafter, a display device according to an embodiment will be described with reference to FIGS. 6 to 10. In the description of the display device according to an embodiment illustrated in FIGS. 6 to 10, contents that are the same as those described with reference to FIGS. 1 to 5B are not described again, but their differences will be mainly described.

FIG. 6 is a cross-sectional view of an embodiment of a display module included in a display device according to an embodiment. FIG. 6 may be a cross-sectional view taken along line II-II' of FIG. 2.

Referring to FIG. 6, a display module DM-1 according to an embodiment further includes an auxiliary layer SAL, as compared to the display module DM illustrated in FIG. 4. The display module DM-1 according to an embodiment includes the base layer BS, the circuit layer DP-CL, a display element layer DP-ED1, the filling layer TP-OL, and the sensor layer TP. In addition, the display module DM-1 according to an embodiment further includes the optical layer RCL.

In the display module DM-1 according to an embodiment, the display element layer DP-ED1 includes the light-emitting elements ED-1, ED-2, and ED-3, the auxiliary pixel defining layer OL, the inorganic protective layer IOL, the pixel defining layer PDL, the auxiliary electrode layer AED, the inorganic layer HRL, and the auxiliary layer SAL. The auxiliary electrode layer AED, the inorganic layer HRL, and the auxiliary layer SAL are sequentially stacked. The stacked structure of the auxiliary electrode layer AED, the inorganic layer HRL, and the auxiliary layer SAL functions as a barrier layer that effectively protects the light-emitting elements ED-1, ED-2, and ED-3 disposed below the stacked structure.

In an embodiment illustrated in FIG. 6, the filling layer TP-OL is disposed on the auxiliary layer SAL. The filling layer TP-OL is disposed directly on the auxiliary layer SAL. The filling layer TP-OL covers the auxiliary layer SAL, and is a single layer on the entirety of the light-emitting regions PXA-R, PXA-G, and PXA-B and the non-light-emitting region NPXA.

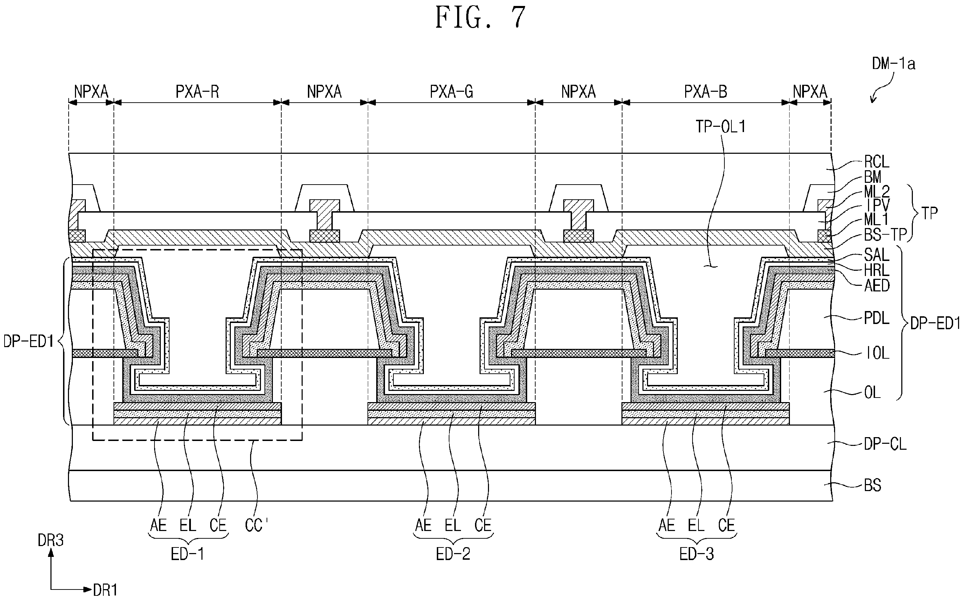

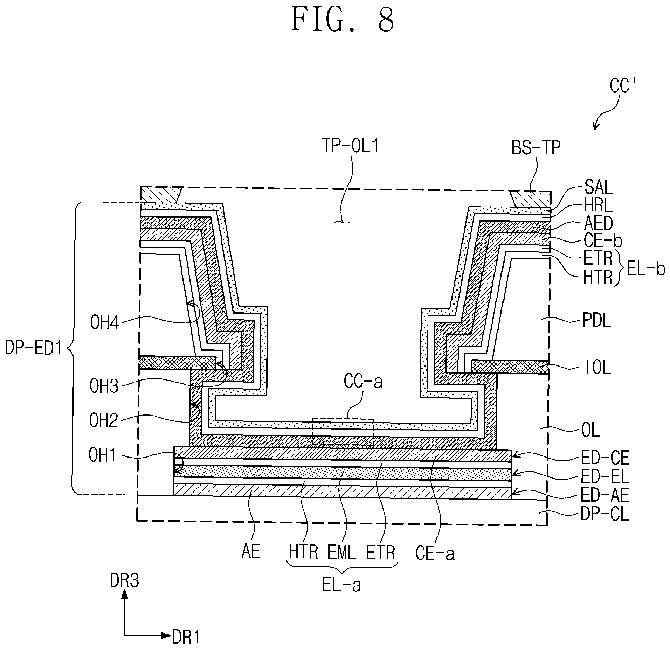

FIG. 7 is a cross-sectional view of an embodiment of a display module in a display device. FIG. 8 is a cross-sectional view of a portion of a display module. FIG. 7 is a cross-sectional view taken along line II-II' of FIG. 2. FIG. 8 is a cross-sectional view of a region CC' of FIG. 7.

Referring to FIGS. 7 and 8, compared to the display module DM illustrated in FIG. 4, a display module DM-1a according to an embodiment further includes an auxiliary layer SAL, and differs in that the filling layer TP-OL1 is patterned.

The display module DM-1a according to an embodiment includes the base layer BS, the circuit layer DP-CL, the display element layer DP-ED1, the filling layer TP-OL, and the sensor layer TP. In addition, the display module DM-1a according to an embodiment may further include the optical layer RCL.

In the display module DM-1a according to an embodiment, the display element layer DP-ED1 includes the light-emitting element layers ED-1, ED-2, and ED-3, the auxiliary pixel defining layer OL, the inorganic protective layer IOL, the pixel defining layer PDL, the auxiliary electrode layer AED, the inorganic layer HRL, and the auxiliary layer SAL. The auxiliary electrode layer AED, the inorganic layer HRL, and the auxiliary layer SAL are sequentially stacked. The stacked structure of the auxiliary electrode layer AED, the inorganic layer HRL, and the auxiliary layer SAL functions as a barrier layer that effectively protects the light-emitting elements ED-1, ED-2, and ED-3 disposed below the stacked structure.

In an embodiment, the filling layer TP-OL1 is disposed on the auxiliary layer SAL. The filling layer TP-OL1 is disposed directly on the auxiliary layer SAL. The filling layer TP-OL1 is patterned to overlap the light-emitting regions PXA-R, PXA-G, and PXA-B but not to overlap the non-light-emitting region NPXA. The filling layer TP-OL1 is patterned so as not to overlap at least a portion of the pixel defining layer PDL.

The filling layer TP-OL1 covers the auxiliary layer SAL and fills a portion of the second to fourth openings OH2, OH3, and OH4. The sensor layer TP is disposed directly on a portion of the auxiliary layer SAL that is not covered by the filling layer TP-OL1. For example, the sensing base layer BS-TP is disposed directly on an upper surface of the auxiliary layer SAL that is not covered and is exposed by the filling layer TP-OL1. In an embodiment, the portion of the sensing base layer BS-TP disposed on the filling layer TP-OL1 protrudes above the portion of the sensing base layer BS-TP disposed directly on the auxiliary layer SAL.

Referring to FIG. 8, in an embodiment, the first electrode AE, the first sub-functional layer EL-a, and the first sub-electrode part CE-a that are disposed in the first opening OH1 are protected by the stacked structure of the auxiliary electrode layer AED, the inorganic layer HRL, and the auxiliary layer SAL. The stacked structure of the auxiliary electrode layer AED, the inorganic layer HRL, and the auxiliary layer SAL covers the light-emitting elements ED-1, ED-2, and ED-3 disposed below the stacked structure and the exposed auxiliary pixel defining layer OL, and functions as a barrier layer.

In an embodiment described with reference to FIGS. 6 to 8, the auxiliary layer SAL, which is a self-assembled monolayer, protects the light-emitting elements ED-1, ED-2, and ED-3 disposed below the auxiliary layer and prevents penetration of moisture during a cleaning process after the auxiliary layer is provided.

A contact angle of water on the upper surface of the auxiliary layer SAL, which is spaced apart from the inorganic layer HRL, is about 90 degrees or more. For example, the contact angle of water on the upper surface of the auxiliary layer SAL is about 100 degrees or more.

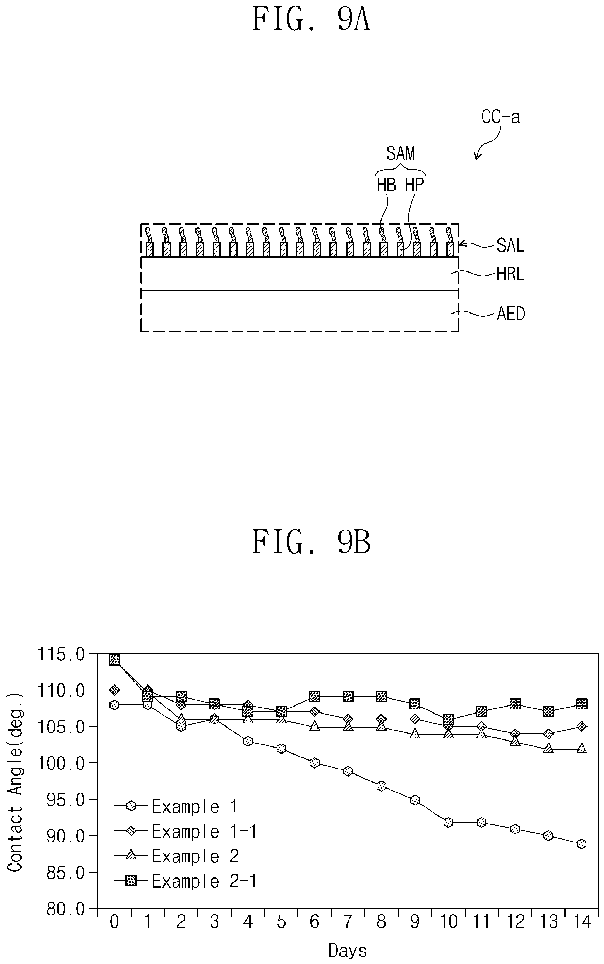

FIG. 9A is an enlarged cross-sectional view of a portion of a display module according to an embodiment. FIG. 9A illustrates a region CC-a of FIG. 8. Referring to FIG. 9A, in an embodiment, the auxiliary layer SAL includes organic molecules SAM that include a hydrophilic portion HP and a hydrophobic portion HB. In an embodiment, the auxiliary layer SAL is a self-assembled monolayer formed of the organic molecules SAM.

In an embodiment, the organic molecules SAM include a silane-based moiety in the hydrophilic portion HP and a fluoro-based moiety in the hydrophobic portion HB. For example, the auxiliary layer SAL includes at least one of tridecafluoro-1,2,2-tetrahydrooctyl trichlorosilane (FOTS), perfluorodecyltrichlorosilane (FDTS), i-butyltrichlorosilane (IBTCS), decyltrichlorosilane (DTCS), octadecyl trichlorosilane (OTS), octyltrichlorosilane (OTCS), n-dodecyltrichlorosilane (DDTCS), trichloro(n-dodecyl)silane (FNTS), trichloro(3,3,3-trifluoropropyl)silane (FPTS), or methoxy polyethylene glycol silane (mPEGS). Specifically, the auxiliary layer SAL includes at least one of FOTS or FDTS.

The hydrophilic portion HP of the organic molecules SAM is disposed adjacent to the inorganic layer HRL, and the hydrophobic portion HB of the organic molecule SAM is spaced apart from the inorganic layer HRL. The hydrophilic portion HP of the organic molecule SAM increases adhesion in the inorganic layer HRL so that the stacked structure of the inorganic layer HRL and the auxiliary layer SAL effectively function as a barrier. In addition, since the hydrophobic portion HB of the organic molecule SAM exhibits a liquid repellent property, water provided in the subsequent cleaning process can be prevented from penetrating into the light-emitting elements disposed therebelow.

FIG. 9B is a graph showing a change in the contact angle of water over time. In FIG. 9B, Examples 1 and 2 show the change in the contact angle of water over time on an upper portion of the auxiliary layer in the single-layer structure of the auxiliary layer. In addition, Examples 1-1 and 2-1 show the change in the contact angle of water over time in the stacked structure of the inorganic layer and the auxiliary layer. The auxiliary layer used in each of Examples 1 and 1-1 is a self-assembled monolayer containing FOTS, and the auxiliary layer used in each of Examples 2 and 2-1 is a self-assembled monolayer containing FDTS. In addition, the inorganic layer used in each of Example 1-1 and Example 2-1 contains silicon nitride.

Referring to FIG. 9B, even after 10 days have elapsed, the contact angle of water on the upper portion of the auxiliary layer maintains an angle of about 90 degrees or more. Therefore, the hydrophobic characteristics of the upper surface of the auxiliary layer are maintained for a long time when the auxiliary layer is formed of organic molecules that include a hydrophilic portion and a hydrophobic portion. That is, as the auxiliary layer is introduced, the auxiliary layer sufficiently delays the penetration of moisture provided in a cleaning process, etc., of a display module manufacturing process, and thus process stability during manufacturing of the display module is increased and reliability of the display device is increased.

In addition, considering the change in the contact angle of Examples 1-1 and 2-1, the contact angle of water is maintained greater when the same time elapses as compared to Examples 1 and 2. This is because the inorganic layer serves as an adhesive layer to maintain the arrangement of the organic molecules in the auxiliary layer, thereby further delaying moisture penetration.

Considering the results of FIG. 9B, a display device according to an embodiment effectively seals each of the light-emitting elements by including a stacked structure of an inorganic layer and an auxiliary layer that covers the light-emitting element and minimizes moisture penetration during a manufacturing process, thereby increasing reliability characteristics.

For example, in an embodiment illustrated in FIGS. 6 to 8, display modules DM-1 and DM-1a protect the light-emitting elements ED-1, ED-2, and ED-3 in the light-emitting regions PXA-R, PXA-G, and PXA-B by including a stacked structure of the auxiliary electrode layer AED, the inorganic layer HRL, and the auxiliary layer SAL that covers the light-emitting element ED-1, ED-2, and ED-3, thereby increasing reliability characteristics. In addition, in an embodiment, the first electrode AE, the first sub-functional layer EL-a, and the first sub-electrode part CE-a of the light-emitting elements ED-1, ED-2, and ED-3 are disposed in the first opening OH1, and each of the light-emitting elements is sealed and protected in a stacked structure of the auxiliary electrode layer AED, the inorganic layer HRL, and the auxiliary layer SAL. Accordingly, since limitations such as propagation of defects in the encapsulation member, which are caused when the typical encapsulation member covers the entirety of the light-emitting elements as a common layer, are prevented, a yield of the display device manufacturing process is increased.

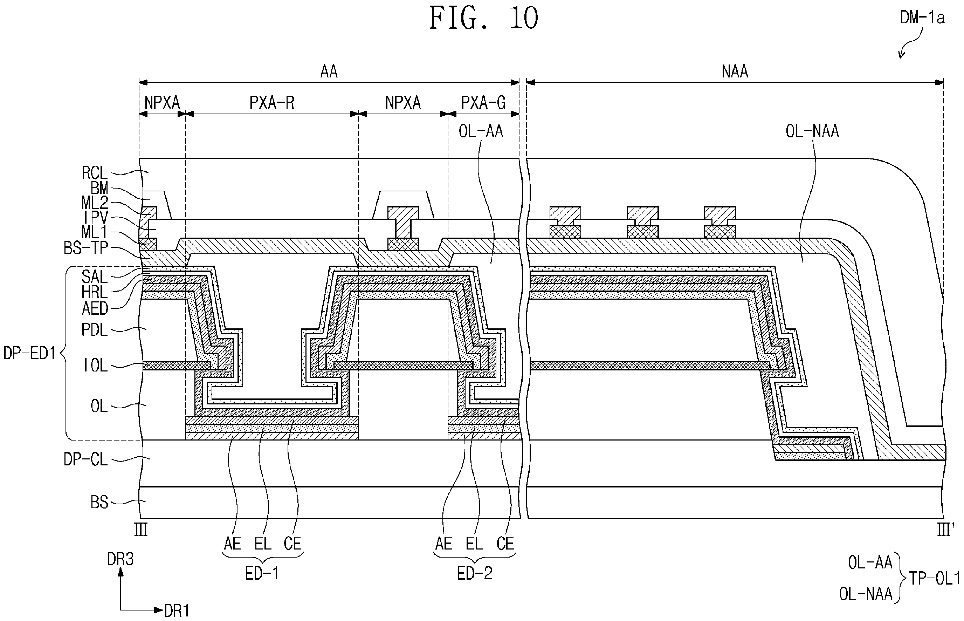

FIG. 10 is a cross-sectional view of a display module according to an embodiment. FIG. 10 illustrates a section taken along line III-III' of FIG. 2. FIG. 10 displays the active region AA of the display module DM-1a, which is illustrated in FIG. 7, and the peripheral region NAA of the display module DM-1a, which is not illustrated in FIG. 7, together.

Referring to FIG. 10, in the display module DM-1a according to an embodiment, the filling layer TP-OL1 includes a first filling part OL-AA disposed in the active region AA and a second filling part OL-NAA disposed in the peripheral region NAA. In the active region AA, the first filling part OL-AA overlaps the entirety of the light-emitting regions PXA-R, PXA-G, and PXA-B (FIG. 7) and a portion of the first filling part OL-AA is patterned so as not to overlap the non-light-emitting region NPXA. In addition, the first filling part OL-AA overlaps the entirety of the light-emitting regions PXA-B, which is not shown in FIG. 10 for convenience of illustration. In addition, the second filling part OL-NAA disposed in the peripheral region NAA is not patterned and covers the entirety of the display element layer DP-ED1 in the peripheral region NAA. For example, even when the filling layer TP-OL1 is patterned and provided as illustrated in FIG. 7, it may be a single layer without being patterned to sufficiently cover an edge portion of the display element layer DP-ED1 in the peripheral region NAA.

In addition, although not illustrated, in the display modules DM and DM-1 according to an embodiment illustrated in FIGS. 4 and 6, the filling layer TP-OL is a single layer that covers an edge portion of the display layer DP in the peripheral region NAA. For example, in the display modules DM and DM-1 according to an embodiment illustrated in FIGS. 4 and 6, the filling layer TP-OL is a single common layer in the entirety of the active region and the peripheral region.

A display device according to an embodiment that includes a display module according to an embodiment illustrated in FIGS. 6 to 10 includes an auxiliary pixel defining layer in which two or more undercut-shaped stepped portions are formed, and an inorganic protective layer, and the configurations of the light-emitting element disposed in the undercut portion are effectively covered by the stacked structure of the auxiliary electrode layer, the inorganic layer, and the auxiliary layer. Accordingly, even when a defect occurs in a portion of the light-emitting region, the defective portion does not propagate to an adjacent light-emitting region and the light-emitting element disposed in the undercut portion is protected by the stacked structure of the auxiliary electrode layer, the inorganic layer, and the auxiliary layer, etc., so that a display device exhibits increased reliability characteristics.

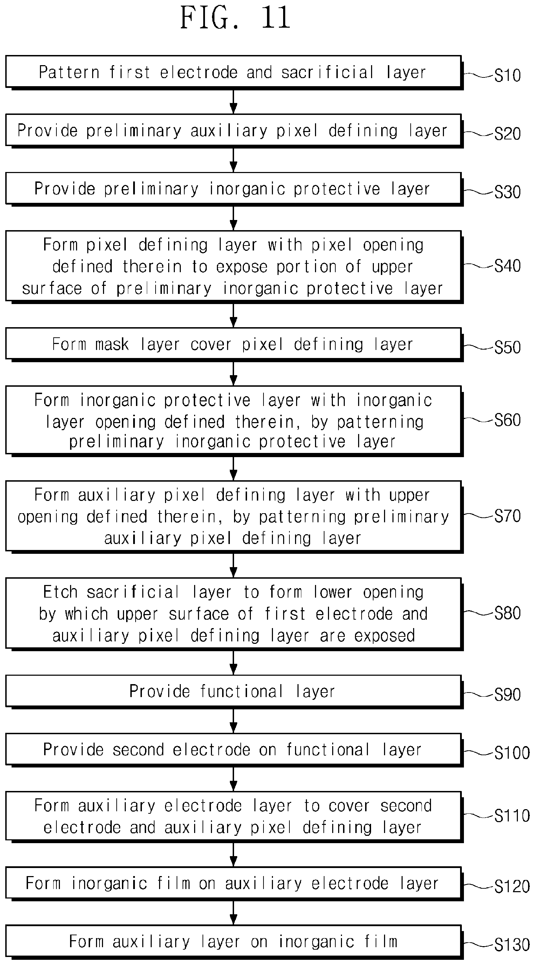

Hereinafter, a method for manufacturing a display device according to an embodiment will be described with reference to FIGS. 11 to 12I, etc. In a description of a method for manufacturing a display device according to an embodiment described with reference to FIGS. 11 to 12I, etc., contents described with reference to FIGS. 1 to 10 are not described again, but their differences will be mainly described.

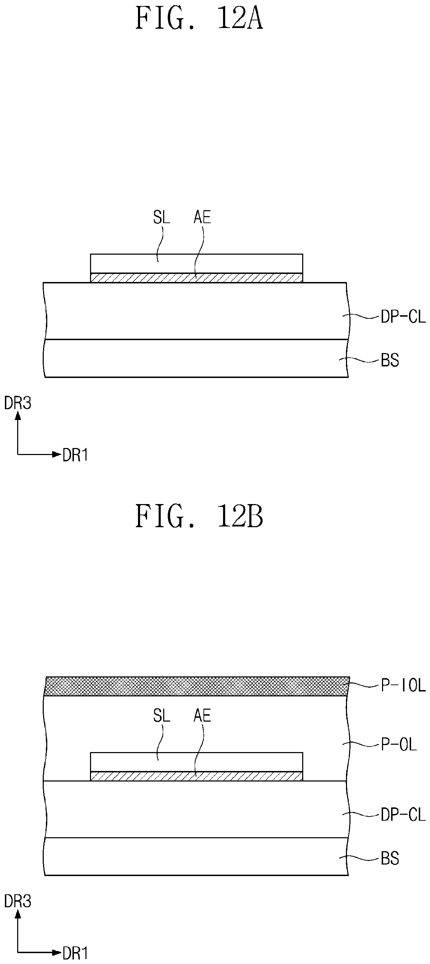

FIG. 11 is a flowchart of a method for manufacturing a display device according to an embodiment. FIGS. 12A to 12I illustrate operations of a method for manufacturing a display device according to an embodiment. The operations of a method for manufacturing a display device according to an embodiment illustrated in FIGS. 12A to 12I may be sequentially performed.

A method for manufacturing a display device according to an embodiment of the inventive concept includes: pattering a first electrode and a sacrificial layer (S10); providing a preliminary auxiliary pixel defining layer (S20); providing a preliminary inorganic protective layer (S30); forming a pixel defining layer with a pixel opening formed therein that exposes a portion of an upper surface of the preliminary inorganic protective layer (S40); forming a mask layer that covers the pixel defining layer (S50); forming an inorganic protective layer with an opening formed therein, by patterning the preliminary inorganic protective layer (S60); forming an auxiliary pixel defining layer with an upper opening formed therein, by patterning the preliminary auxiliary pixel defining layer (S70); etching the sacrificial layer to form a lower opening by which an upper surface of the first electrode and the auxiliary pixel defining layer are exposed (S80); providing a functional layer (S90); providing a second electrode on the functional layer (S100); forming an auxiliary electrode layer that covers the second electrode and the auxiliary pixel defining layer (S110); and forming an inorganic layer on the auxiliary electrode layer (S120). In addition, a method for manufacturing a display device according to an embodiment further includes forming an auxiliary layer on the inorganic layer (S130) after forming the inorganic layer on the auxiliary electrode layer (S120).

FIG. 12A illustrates the pattering of the first electrode and the sacrificial layer (S10). Referring to FIG. 12A, in an embodiment, the circuit layer DP-CL is disposed on the base layer BS, and a patterned first electrode AE and the sacrificial layer SL are disposed on the circuit layer DP-CL. For example, the sacrificial layer SL includes at least one of indium zinc oxide (IZO) or indium gallium zinc oxide (IGZO). For example, the first electrode AE and the sacrificial layer SL are patterned in the same process. However, an embodiment of the inventive concept is not necessarily limited thereto, and in an embodiment, the sacrificial layer SL is patterned to correspond to the shape of the first electrode AE after the first electrode AE is patterned.

FIG. 12B illustrates the providing of the preliminary auxiliary pixel defining layer (S20) and the providing of the preliminary inorganic protective layer (S30). Referring to FIG. 12B, in an embodiment, a preliminary auxiliary pixel defining layer P-OL is disposed on the sacrificial layer SL and the circuit layer DP-CL. The preliminary auxiliary pixel defining layer P-OL entirely overlaps the circuit layer DP-CL and covers the patterned first electrode AE and the sacrificial layer SL. In addition, a preliminary inorganic protective layer P-IOL is disposed on the auxiliary pixel defining layer P-OL and overlaps an entirety of the preliminary auxiliary pixel defining layer P-OL.

For example, the preliminary auxiliary pixel defining layer P-OL is formed by providing a polyacrylate-based resin or a polyimide-based resin. The preliminary auxiliary pixel defining layer P-OL is formed through a process of coating and curing the polyacrylate-based resin or the polyimide-based resin.

In addition, the preliminary inorganic protective layer P-IOL is formed by depositing, for example, silicon nitride on the preliminary auxiliary pixel defining layer P-OL.

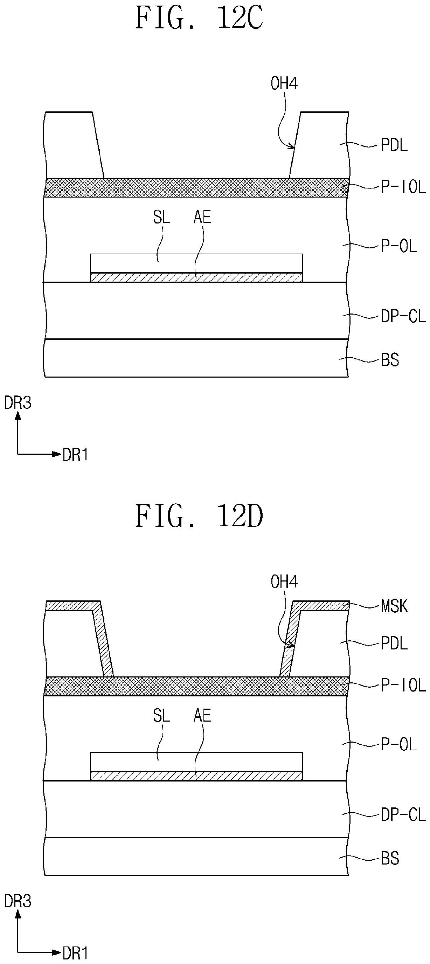

FIG. 12C illustrates the forming of the pixel defining layer with a pixel opening formed therein that exposes a portion of an upper surface of the preliminary inorganic protective layer (S40). Referring to FIG. 12C, in an embodiment, the pixel defining layer PDL is disposed on the preliminary inorganic protective layer P-IOL. The fourth opening OH4 is formed in the pixel defining layer PDL. The pixel defining layer PDL may be formed of a polymer resin.

FIG. 12D illustrates the forming of the mask layer that covers the pixel defining layer (S50). Referring to FIG. 12D, in an embodiment, the mask layer MSK is disposed on and covers the pixel defining layer PDL and the preliminary inorganic protective layer P-IOL, and is patterned to expose an upper surface of the preliminary inorganic protective layer P-IOL. The mask layer MSK is formed of the same material as the sacrificial layer SL. For example, the mask layer MSK includes at least one of indium zinc oxide (IZO) or indium gallium zinc oxide (IGZO).

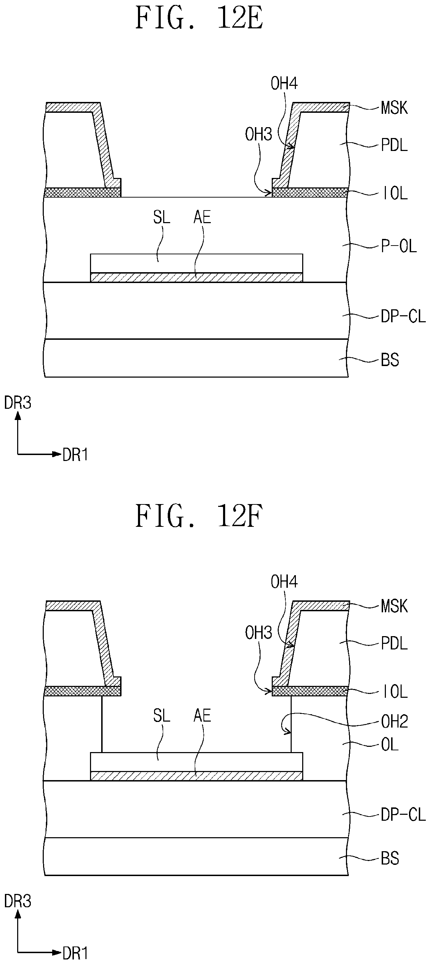

FIG. 12E illustrates the forming of the inorganic protective layer with an opening formed therein, by patterning the preliminary inorganic protective layer (S60). Referring to FIG. 12E, in an embodiment, the inorganic protective layer IOL with the opening, namely the third opening OH3, formed therein is formed by patterning with the mask layer MSK the preliminary inorganic protective layer P-IOL. The opening OH3 is formed by etching the preliminary inorganic protective layer using the mask layer MSK. A width of the formed opening OH3 along the first directional axis DR1 is less than a width of the pixel opening OH4 along the first directional axis DR1.

FIG. 12F illustrates the forming of the auxiliary pixel defining layer with the upper opening formed therein, by patterning the preliminary auxiliary pixel defining layer (S70). Referring to FIG. 12F, in an embodiment, the auxiliary pixel defining layer OL with the upper opening, that is the second opening OH2, formed therein is formed by patterning with the mask layer MSK and the inorganic protective layer IOL the preliminary auxiliary pixel defining layer P-OL. The sacrificial layer SL functions as an etching stopper. The preliminary auxiliary pixel defining layer P-OL is etched until the upper surface of the sacrificial layer SL is exposed.

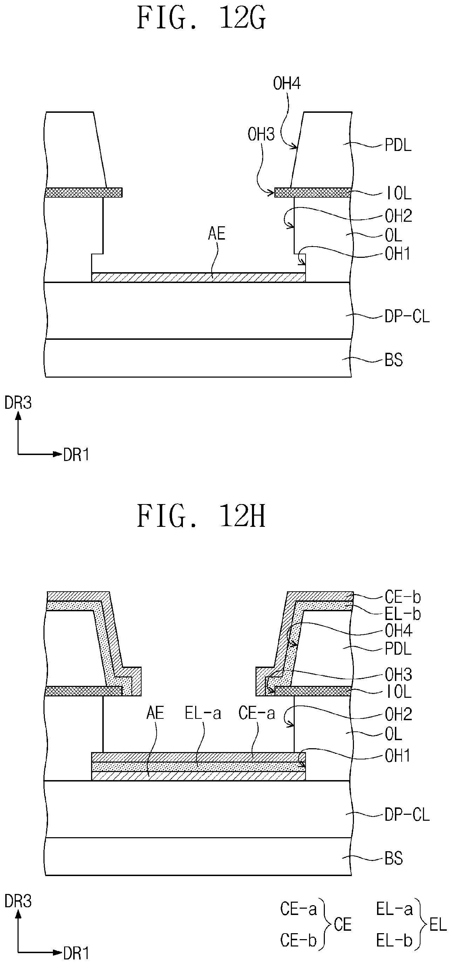

FIG. 12G illustrates the etching of the sacrificial layer to form the lower opening by which an upper surface of the first electrode and the auxiliary pixel defining layer are exposed (S80). Referring to FIG. 12G, in an embodiment, when forming the auxiliary pixel defining layer and the upper opening, the exposed sacrificial layer SL is etched and removed by patterning the preliminary auxiliary pixel defining layer (S70), and a lower opening is formed in a portion in which the sacrificial layer SL was disposed. The lower opening, which is the first opening OH1, is defined by the exposed side surfaces of the auxiliary pixel defining layer OL and the first electrode AE. A portion of the side surface of the auxiliary pixel defining layer OL is exposed in the lower opening OH1, and the upper surface of the first electrode AE is exposed. In addition, when forming the lower opening and exposing the auxiliary pixel defining layer (S80), the mask layer MSK (FIG. 12F) is also etched. The mask layer MSK and the sacrificial layer SL are removed in the same process. However, an embodiment of the inventive concept is not necessarily limited thereto.

FIG. 12H illustrates the providing of the functional layer (S90) and the providing of the second electrode on the functional layer (S100). The providing of the functional layer (S90) includes providing the functional layer on the first electrode, the inorganic protective layer, and the pixel defining layer.

Referring to FIG. 12H, in an embodiment, when providing the functional layer (S90), the hole transport region HTR (FIG. 5A), the light-emitting layer EML (FIG. 5A), and the electron transport region ETR (FIG. 5A) are sequentially disposed. The functional layer EL provided in this step (S90) includes a first sub-functional layer EL-a and a second sub-functional layer EL-b. The first sub-functional layer EL-a and the second sub-functional layer EL-b are disconnected from each other. The functional layer EL is not disposed in the upper opening OH2. A portion of the auxiliary pixel defining layer OL is exposed where the functional layer EL is not disposed. The first sub-functional layer EL-a is disposed on the first electrode AE in the lower opening OH1, and the second sub-functional layer EL-b spaced apart from the first sub-functional layer EL-a is disposed to cover the exposed side and upper surface of the inorganic protective layer IOL and the side and upper surface of the pixel defining layer PDL. In addition, the first sub-functional layer EL-a includes the hole transport region, the light-emitting layer, and the electron transport region, and the second sub-functional layer EL-b includes the hole transport region and the electron transport region. The second sub-functional layer EL-b does not include the light-emitting layer, or includes the light-emitting layer only in a portion adjacent to the first sub-functional layer EL-a.

The second electrode CE provided in this step (S100) includes the first sub-electrode part CE-a and the second sub-electrode part CE-b. The first sub-electrode part CE-a is disposed on the first sub-functional layer El-a, and the second sub-electrode part CE-b is disposed on the second sub-functional layer EL-b.

The first sub-electrode part CE-a and the second sub-electrode part CE-b are disconnected from each other. The second electrode CE is not disposed in the upper opening OH2. A portion of the auxiliary pixel defining layer OL is exposed where the second electrode CE is not disposed. The first sub-electrode part CE-a overlaps the first electrode AE in the lower opening OH1 and the second sub-electrode part CE-b is spaced apart from the first sub-electrode part CE-a and covers the exposed side and upper surface of the inorganic protective layer IOL, and the side and upper surface of the pixel defining layer PDL.

The steps of providing the functional layer (S90) and providing the second electrode (S100) respectively include forming a functional layer and a second electrode using a deposition method.

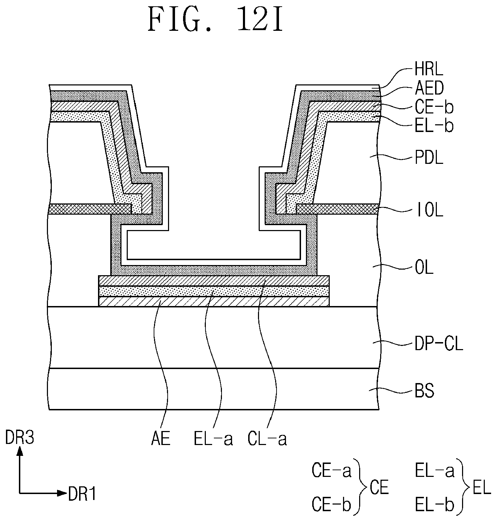

FIG. 12I illustrates the forming of the auxiliary electrode layer that covers the second electrode and the auxiliary pixel defining layer (S110) and the forming of the inorganic layer on the auxiliary electrode layer (S120).

The auxiliary electrode layer AED is provided to cover the exposed auxiliary pixel defining layer OL where the second electrode CE, which includes the first sub-electrode part CE-a and the second sub-electrode part CE-b, is not disposed. The auxiliary electrode layer AED overlaps the entirety of the light-emitting element and the pixel defining layer PDL.

The forming of the auxiliary electrode layer (S110) includes forming an auxiliary electrode layer that may contain a transparent metal oxide by using an atomic layer deposition method. For example, the auxiliary electrode layer AED is formed by atomic layer deposition using an indium precursor. The auxiliary electrode layer AED may include ITO. The auxiliary electrode layer AED may be provided as a single layer or a plurality of layers.

The inorganic layer HRL is disposed to cover the entirety of the auxiliary electrode layer AED. The inorganic layer HRL may include silicon nitride, etc. In addition, the inorganic layer HRL is provided using an atomic layer deposition method. For example, the forming of the inorganic layer (S120) includes forming a silicon nitride-containing inorganic layer using atomic layer deposition.

In addition, a method for manufacturing a display device according to an embodiment further includes forming other constituent layers, such as a filling layer, a sensor layer, etc., after the manufacturing operations described with reference to FIGS. 12A to 12I.

For example, a method according to an embodiment for manufacturing a display device that includes the display module DM illustrated in FIG. 4, etc., further includes forming a filling layer TP-OL on the inorganic layer HRL, and forming a sensor layer TP on the filling layer. In an embodiment, the sensor layer TP includes a sensing base layer BS-TP, a first conductive layer ML1, a sensing insulating layer IPV, and a second conductive layer ML2 that is sequentially stacked.

In addition, a method for manufacturing a display device according to an embodiment further includes forming, after the forming of the inorganic layer, an auxiliary layer on the inorganic layer HRL that is a self-assembled monolayer that includes a hydrophilic portion and a hydrophobic portion (S120). For example, a method for manufacturing a display device that includes the display modules DM-1 and DM-1a according to an embodiment illustrated in FIGS. 6 and 7, etc., further includes forming, on the inorganic layer HRL, an auxiliary layer SAL with the organic molecules that contain the hydrophilic portion and the hydrophobic portion.

A display device according to an embodiment includes an auxiliary pixel defining layer that has an undercut shape and an inorganic protective layer, and effectively covers configurations of light-emitting elements disposed in the undercut portion with an auxiliary electrode layer and an inorganic layer, thereby increasing reliability characteristics. For example, in a display device according to an embodiment, the light-emitting elements are arranged to be disconnected from adjacent light-emitting elements in the undercut-shaped opening, and each of the light-emitting elements disposed in the opening are sealed with an auxiliary electrode layer and an inorganic layer. Accordingly, a display device according to an embodiment exhibits increased reliability, by preventing a case in which an encapsulation member provided on a light-emitting element lacks an undercut-shaped opening, which allows defects in the encapsulation member to propagate to the adjacent light-emitting region.

In addition, a method for manufacturing a display device according to an embodiment includes forming the auxiliary electrode layer and the inorganic layer to sufficiently cover the light-emitting elements disposed in the undercut portion, and effectively encapsulating each of the light-emitting elements that correspond to each light-emitting region. Accordingly, a display device with increased reliability can be manufactured.

A display device according to an embodiment includes an auxiliary electrode layer and an inorganic layer that are disposed on the light-emitting element, and sufficiently cover the light-emitting layer of each light-emitting element for each pixel in the opening, thereby exhibiting increased reliability.

A method for manufacturing a display device according to an embodiment can be used to manufacture a display device with increased reliability characteristics, and includes a method of forming an auxiliary electrode layer and an inorganic layer that cover a portion of a light-emitting element disposed in the opening.

Although embodiments of the present disclosure have been described, it is understood that embodiments of the present disclosure should not be limited thereto, and that various changes and modifications can be made by one ordinary skilled in the art within the scope of embodiments of the present disclosure as hereinafter claimed.

## Claims

1. A display device, comprising:
an auxiliary pixel defining layer, that includes a first opening and a second opening formed above the first opening;
an inorganic protective layer disposed on the auxiliary pixel defining layer and that includes a third opening formed above the second opening;
a pixel defining layer disposed on the inorganic protective layer and that includes a fourth opening formed above the third opening;
a light-emitting element;
an auxiliary electrode layer that covers the pixel defining layer and the light-emitting element; and
an inorganic layer disposed on the auxiliary electrode layer and that overlaps the pixel defining layer and the light-emitting element.

2. The display device of claim 1, further comprising:
a base layer; and
a circuit layer disposed on the base layer;
wherein the auxiliary pixel defining layer and the light-emitting element are disposed on the circuit layer and the first opening is adjacent to the circuit layer, and
wherein in a cross section perpendicular to the base layer, a width of the first opening is greater than a width of the second opening, the width of the second opening is greater than a width of the third opening, and a width of the fourth opening is greater than the width of the third opening.

3. The display device of claim 2, wherein
the light-emitting element includes a first electrode, a functional layer disposed on the first electrode, and a second electrode disposed on the functional layer,
the first electrode is disposed in the first opening,
the functional layer comprises a first sub-functional layer disposed on the first electrode defining the first opening, and a second sub-functional layer disconnected from the first sub-functional layer and disposed on a side surface of the inorganic protective layer defining the third opening, an upper surface of the inorganic protective layer exposed by the fourth opening, a side surface of the pixel defining layer in the fourth opening, and an upper surface of the pixel defining layer, and
the second electrode includes a first sub-electrode part disposed on the first sub-functional layer in the first opening, and a second sub-electrode part disconnected from the first sub-electrode part and disposed on the second sub-functional layer.

4. The display device of claim 3, wherein the auxiliary electrode layer is disposed directly on the first sub-electrode part and the second sub-electrode part, and electrically connects the first sub-electrode part and the second sub-electrode part.

5. The display device of claim 3 or claim 4, wherein the first sub-functional layer and the second sub-functional layer are disconnected, and the auxiliary pixel defining layer is exposed at a portion where the first sub-electrode part and the second sub-electrode part are disconnected, and
the auxiliary electrode layer covers the first sub-electrode part, the second sub-electrode part, and the auxiliary pixel defining layer exposed where the first sub-electrode part and the second sub-electrode part are disconnected.

6. The display device of claim 5, wherein the inorganic layer is disposed directly on the auxiliary electrode layer and overlaps an entirety of the auxiliary electrode layer.

7. The display device of claim 6, further comprising an auxiliary layer disposed on the inorganic layer, wherein the auxiliary layer includes organic molecules that each include a hydrophilic portion adjacent to the inorganic layer and a hydrophobic portion spaced apart from the inorganic layer.

8. The display device of claim 7, wherein the auxiliary layer is a self-assembled monolayer.

9. The display device of claim 7 or claim 8, wherein a contact angle of water on an upper surface of the auxiliary layer is about 90 degrees or more.

10. The display device of any one of claims 7 to 9, wherein the auxiliary layer includes at least one of tridecafluoro-1,2,2-tetrahydrooctyl trichlorosilane (FOTS), perfluorodecyltrichlorosilane (FDTS), i-butyltrichlorosilane (IBTCS), decyltrichlorosilane (DTCS), octadecyl trichlorosilane (OTS), octyltrichlorosilane (OTCS), n-dodecyltrichlorosilane (DDTCS), trichloro(n-dodecyl)silane (FNTS), trichloro(3,3,3-trifluoropropyl)silane (FPTS), or methoxy polyethylene glycol silane (mPEGS).

11. The display device of any one of claims 3 to 10, wherein the first sub-functional layer comprises a hole transport region, a light-emitting layer, and an electron transport region that are sequentially stacked, and
the second sub-functional layer includes the hole transport region and the electron transport region, and does not include the light-emitting layer.

12. The display device of any one of claims 3 to 11, wherein an edge of the first electrode, an edge of the first sub-functional layer, and an edge of the first sub-electrode part overlap each other in the first opening.

13. The display device of claim 12, wherein the edge of the first electrode, the edge of the first sub-functional layer, and the edge of the first sub-electrode part are in contact with the auxiliary pixel defining layer exposed by the first opening.

14. The display device of any one of claims 1 to 13, wherein the auxiliary electrode layer includes a transparent metal oxide.

15. The display device of any one of claims 1 to 14, wherein the auxiliary electrode layer is provided by an atomic layer deposition method that uses an indium precursor.
